# EUROPEAN PATENT APPLICATION

(11) **EP 4 796 315 A1**
(43) Date of publication of application: **26.08.2026**
(21) Application number: 26160734.5
(22) Date of filing: 25.02.2026
(51) Int. Cl.: B32B 7/12, B32B 27/30, C08F 2/48, C08F 220/18, C08F 283/12, C09J 4/06, G06F 1/16

(54) **ADHESIVE COMPOSITION, DISPLAY APPARATUS, AND ELECTRONIC APPARATUS**

(30) Priority: 25.02.2025 KR 20250024585
(71) Applicant: Samsung Display Co., Ltd., Yongin-si, Gyeonggi-do 17113 (KR)
(72) Inventor: SEOL, Junyeong, 17113 Yongin-si (KR)
(74) Representative: Marks & Clerk LLP

(57) **Abstract**

An adhesive composition that is easy to fold and has excellent or suitable impact resistance, a display apparatus, and an electronic apparatus are disclosed. The adhesive composition includes a first acrylate-based compound including an acryloyl group, a second acrylate-based compound different from the first acrylate-based compound and including at least one selected from among a carboxyl group, a hydroxyl group, an amide group, an amino group, and an epoxy group, and an acryloyl group, a siloxane-based compound including a siloxane group, and a crosslinking agent.

## Description

### CROSS-REFERENCE TO RELATED APPLICATION

### BACKGROUND

### 1. Field

One or more embodiments of the present disclosure relate to an adhesive composition, a display apparatus, and an electronic apparatus. For example, one or more embodiments of the present disclosure relate to an adhesive composition that facilitates folding (e.g., that is easy to fold) and provides excellent or suitable impact resistance, a display apparatus including such an adhesive composition, and an electronic apparatus including such a display apparatus.

### 2. Description of the Related Art

To support one or more suitable functions, electronic apparatuses often include display apparatuses that provide visual information, such as images, to users. To enable bending or folding, display apparatuses are increasingly required or desired to be flexible, lightweight, and slim.

Display apparatuses may have a structure in which a plurality of elements are stacked. An adhesive layer, including a cured material of an adhesive composition, is used to attach (bond) one or more of these plurality of elements together. To facilitate (support) folding functionality, the adhesive layer should not significantly increase the repulsive force if (e.g., when) the display apparatus is folded. Additionally, the adhesive layer should enhance the impact resistance of the display apparatus, which may otherwise be compromised due to weight reduction and thinning.

### SUMMARY

However, in a display apparatus according to the related art, improvements in impact resistance may hinder the ability of the apparatus to fold easily.

One or more aspects of embodiments of the present disclosure are directed toward an adhesive composition that is easy to fold and has an excellent or suitable impact resistance, a display apparatus, and an electronic apparatus. However, one or more embodiments described herein are only examples, and embodiments of the present disclosure are not limited thereto.

Additional aspects of embodiments will be set forth in part in the description which follows and, in part, will be apparent from the description or may be learned by practice of the presented embodiments of the disclosure.

According to one or more embodiments, an adhesive composition includes a first acrylate-based compound including an acryloyl group, a second acrylate-based compound different from the first acrylate-based compound and including at least one selected from among a carboxyl group, a hydroxyl group, an amide group, an amino group, and an epoxy group, and an acryloyl group, a siloxane-based compound including a siloxane group, and a crosslinking agent.

If (e.g., when) a total weight of the first acrylate-based compound, the second acrylate-based compound, the siloxane-based compound, and the crosslinking agent in the adhesive composition is 100 wt% (e.g., based on 100 wt% of the first acrylate-based compound, the second acrylate-based compound, the siloxane-based compound, and the crosslinking agent in the adhesive composition), the adhesive composition may include about 70 wt% to about 80 wt% of the first acrylate-based compound, the adhesive composition may include about 10 wt% to about 20 wt% of the second acrylate-based compound, the adhesive composition may include about 1 wt% to about 10 wt% of the siloxane-based compound, and the adhesive composition may include about 0.1 wt% to about 3 wt% of the crosslinking agent.

To put it another way, based on 100 wt% of the first acrylate-based compound, the second acrylate-based compound, the siloxane-based compound, and the crosslinking agent, the adhesive composition may include:
about 70 wt% to about 80 wt% of the first acrylate-based compound;
about 10 wt% to about 20 wt% of the second acrylate-based compound;
about 1 wt% to about 10 wt% of the siloxane-based compound; and
about 0.1 wt% to about 3 wt% of the crosslinking agent.

The second acrylate-based compound may include at least one selected from among acrylic acid, carboxy ethyl acrylate, carboxy propyl acrylate, carboxy butyl acrylate, hydroxy ethyl acrylate, n-hydroxy propyl acrylate, n-hydroxy butyl acrylate, acrylamide, n-diethyl acrylamide, dimethylaminoethyl acrylate, diethylaminoethyl acrylate, dimethylaminopropyl acrylate, and glycidyl acrylate, and the siloxane-based compound may include at least one selected from among polydimethylsiloxane, polymethylphenylsiloxane, and polydiphenylsiloxane.

The first acrylate-based compound may include a first acrylate-based monomer having an acryloyl group and a polymer obtained by polymerizing the first acrylate-based monomer, and the first acrylate-based monomer may include at least one selected from among 2-ethylhexyl acrylate, butyl acrylate, and ethyl acrylate.

The crosslinking agent may include at least one selected from 1,6-hexanediol diacrylate and dipentaerythritol hexaacrylate.

According to one or more embodiments, a display apparatus includes a display panel including a display element, a cover window arranged on the display panel, and a first adhesive layer arranged between the display panel and the cover window, wherein the first adhesive layer includes a cured material of an adhesive composition, and wherein the adhesive composition includes a first acrylate-based compound including an acryloyl group, a second acrylate-based compound different from the first acrylate-based compound and including at least one selected from among a carboxyl group, a hydroxyl group, an amide group, an amino group, and an epoxy group, and an acryloyl group, a siloxane-based compound including a siloxane group, and a crosslinking agent.

If (e.g., when) a total weight of the first acrylate-based compound, the second acrylate-based compound, the siloxane-based compound, and the crosslinking agent in the adhesive composition is 100 wt% (e.g., based on 100 wt% of the first acrylate-based compound, the second acrylate-based compound, the siloxane-based compound, and the crosslinking agent in the adhesive composition), the adhesive composition may contain about 70 wt% to about 80 wt% of the first acrylate-based compound, the adhesive composition may contain about 10 wt% to about 20 wt% of the second acrylate-based compound, the adhesive composition may contain about 1 wt% to about 10 wt% of the siloxane-based compound, and the adhesive composition may contain about 0.1 wt% to about 3 wt% of the crosslinking agent.

The second acrylate-based compound may include at least one selected from among acrylic acid, carboxy ethyl acrylate, carboxy propyl acrylate, carboxy butyl acrylate, hydroxy ethyl acrylate, n-hydroxy propyl acrylate, n-hydroxy butyl acrylate, acrylamide, n-diethyl acrylamide, dimethylaminoethyl acrylate, diethylaminoethyl acrylate, dimethylaminopropyl acrylate, and glycidyl acrylate, and the siloxane-based compound may include at least one selected from among polydimethylsiloxane, polymethylphenylsiloxane, and polydiphenylsiloxane.

The first acrylate-based compound may include a first acrylate-based monomer having an acryloyl group and a polymer obtained by polymerizing the first acrylate-based monomer, and the first acrylate-based monomer may include at least one selected from among 2-ethylhexyl acrylate, butyl acrylate, and ethyl acrylate.

The crosslinking agent may include at least one selected from 1,6-hexanediol diacrylate and dipentaerythritol hexaacrylate.

The display apparatus may further include a window protective layer arranged on the cover window, and a second adhesive layer arranged between the cover window and the window protective layer, wherein the second adhesive layer may include substantially the same material as the first adhesive layer.

The display apparatus may further include a lower protective layer arranged under the display panel, a barrier layer arranged under the lower protective layer, a support layer arranged under the barrier layer, and a third adhesive layer arranged between the display panel and the lower protective layer, wherein the third adhesive layer may include substantially the same material as the first adhesive layer.

The display apparatus may further include a fourth adhesive layer arranged between the lower protective layer and the barrier layer, wherein the fourth adhesive layer may include substantially the same material as the first adhesive layer.

The display apparatus may further include a fifth adhesive layer arranged between the barrier layer and the support layer, wherein the fifth adhesive layer may include substantially the same material as the first adhesive layer.

The display apparatus may further include an upper protective layer arranged between the display panel and the cover window, and a sixth adhesive layer arranged between the display panel and the upper protective layer, wherein the first adhesive layer may be arranged between the upper protective layer and the cover window, and the sixth adhesive layer may include substantially the same material as the first adhesive layer.

The display apparatus may include a first non-folding area, a second non-folding area, and a foldable area between the first non-folding area and the second non-folding area.

The display apparatus may be folded such that a portion of one surface of the display apparatus and another portion of the one surface of the display apparatus are opposite to (e.g., face) each other.

According to one or more embodiments, an electronic apparatus includes a processor, and a display apparatus controlled or selected by the processor, wherein the display apparatus includes a display panel including a display element, a cover window arranged on the display panel, and a first adhesive layer arranged between the display panel and the cover window, wherein the first adhesive layer includes a cured material of an adhesive composition, and wherein the adhesive composition includes a first acrylate-based compound including an acryloyl group, a second acrylate-based compound different from the first acrylate-based compound and including at least one selected from among a carboxyl group, a hydroxyl group, an amide group, an amino group, and an epoxy group, and an acryloyl group, a siloxane-based compound including a siloxane group, and a crosslinking agent.

If (e.g., when) a total weight of the first acrylate-based compound, the second acrylate-based compound, the siloxane-based compound, and the crosslinking agent in the adhesive composition is 100 wt% (e.g., based on 100 wt% of the first acrylate-based compound, the second acrylate-based compound, the siloxane-based compound, and the crosslinking agent in the adhesive composition), the adhesive composition may contain about 70 wt% to about 80 wt% of the first acrylate-based compound, the adhesive composition may contain about 10 wt% to about 20 wt% of the second acrylate-based compound, the adhesive composition may contain about 1 wt% to about 10 wt% of the siloxane-based compound, and the adhesive composition may contain about 0.1 wt% to about 3 wt% of the crosslinking agent.

To put it another way, based on 100 wt% of the first acrylate-based compound, the second acrylate-based compound, the siloxane-based compound, and the crosslinking agent, the adhesive composition may include:
about 70 wt% to about 80 wt% of the first acrylate-based compound;
about 10 wt% to about 20 wt% of the second acrylate-based compound;
about 1 wt% to about 10 wt% of the siloxane-based compound; and
about 0.1 wt% to about 3 wt% of the crosslinking agent.

The display apparatus may include a first non-folding area, a second non-folding area, and a foldable area between the first non-folding area and the second non-folding area, and the display apparatus may be folded such that a portion of one surface of the display apparatus and another portion of the one surface of the display apparatus are opposite to (e.g., face) each other.

At least some of the above and other features of the invention are set out in the claims.

For example, the adhesive composition as described herein may be advantageous or beneficial in foldable display apparatuses, where mechanical flexibility and impact resistance are needed or desired. By incorporating the acrylate-based compounds, the siloxane-based compounds, and the crosslinking agent that are described in one or more embodiments, the adhesive layers within the display apparatus may maintain structural integrity while allowing repeated folding without significant degradation. This balance of properties supports the formation of a foldable area between non-folding regions, enabling reliable operation and durability in electronic apparatus (devices).

Other aspects, features, and embodiments of the present disclosure will become better understood through the detailed description, the appended claims and equivalents thereof, and the accompanying drawings.

### BRIEF DESCRIPTION OF THE DRAWINGS

The above and other aspects and features of certain embodiments of the present disclosure will be more apparent from the following description taken in conjunction with the accompanying drawings, in which:
FIG. 1A is a schematic block diagram of an electronic apparatus according to one or more embodiments;
FIG. 1B is a schematic view illustrating electronic apparatuses according to one or more embodiments;
FIG. 2 is a schematic perspective view of a display apparatus according to one or more embodiments;
FIG. 3 is a schematic side view of a display apparatus according to one or more embodiments;
FIG. 4 is a schematic cross-sectional view of the display apparatus of FIG. 2 taken along the line I-I' of FIG. 2;
FIG. 5 is a schematic plan view of a portion of a display panel in the display apparatus of FIG. 4;
FIG. 6 is an equivalent circuit diagram of a pixel circuit in the display panel of FIG. 5;
FIG. 7 is a schematic cross-sectional view of the display panel of FIG. 5 taken along the line II-II' of FIG. 5;
FIG. 8 is a graph showing ball drop evaluation results regarding display apparatuses according to Embodiment 1 and Comparative Example 1;
FIG. 9 is a graph showing pen drop evaluation results regarding display apparatuses according to Embodiment 1 and Comparative Example 1; and
FIG. 10 is a schematic cross-sectional view of a display apparatus according to one or more embodiments.

### DETAILED DESCRIPTION

Reference will be made in more detail to one or more embodiments, examples of which are illustrated in the accompanying drawings, wherein like reference numerals refer to like elements throughout the attached drawings and the written description, and duplicative descriptions thereof may not be provided in the specification. In this regard, the subject matter of the present disclosure may be embodied in different forms and should not be construed as being limited to one or more embodiments set forth herein. Rather, these embodiments are provided as examples, by referring to the drawings, to explain the aspects and features of the present disclosure to those skilled in the art.

The utilization of "may" if (e.g., when) describing embodiments of the present disclosure refers to "one or more embodiments of the present disclosure."

In the context of the present application and unless otherwise defined, the terms "use," "using," and "used" may be considered synonymous with the terms "utilize," "utilizing," and "utilized," respectively.

As used herein, the term "and/or" includes any and all combinations of one or more of the associated listed items.

Throughout the disclosure, the expression "at least one of a, b, and c" indicates only a, only b, only c, both (e.g., simultaneously) a and b, both (e.g., simultaneously) a and c, both (e.g., simultaneously) b and c, all of a, b, and c, or variations thereof.

As the present description allows for one or more suitable changes to the disclosed subject matter and embodiments, certain embodiments will be illustrated in the accompanying drawings and described in more detail in the written description. The aspects, effects, and embodiments of the present disclosure and methods for achieving them will be clarified with reference to one or more embodiments and the accompanying drawings described below in more detail. However, the disclosure is not limited to the disclosed embodiments and may be implemented in one or more suitable forms.

While such terms as "first," "second, and/or the like may be used to describe one or more suitable components, such components are not limited to the above terms. The above terms are used to distinguish one component from another.

The singular forms "a," "an," and "the" as used herein are intended to include the plural forms as well unless the context clearly indicates otherwise.

It will be understood that the terms "include," " including," "has" and/or "having" as used herein specify the presence of stated features or components but do not preclude the addition of one or more other features or components. For example, it should be understood that the terms "comprise(s)/comprising," "include(s)/including," or "have/has/having" specify the presence of stated features, integers, steps, operations, elements, and/or components, but do not preclude the presence or addition of one or more other features, integers, steps, operations, elements, components, and/or groups thereof. Also, the terms "comprise(s)/comprising," "include(s)/including," "have/has/having," or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As utilized herein, the terms "substantially," "about," or similar terms are used as terms of approximation and not as terms of degree and are intended to account for the inherent deviations in measured or calculated values that would be recognized by those of ordinary skill in the art. "About" as used herein is inclusive of the stated value and refers to as being within an acceptable range of deviation for the particular value as determined by one of ordinary skill in the art, considering the measurement in question and the error associated with measurement of the particular quantity (e.g., the limitations of the measurement system). For example, "about" may refer to as being within one or more standard deviations or within ±30%, ±20%, ±10%, or ±5% of the stated value. Also, it should be understood that, even if (e.g., when) the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein.

In the present disclosure, "A and/or B" refers to A or B, or A and B. Also, "at least one of A and B" refers to A or B, or A and B.

As used herein, if (e.g., when) an element, such as a layer, a region, a plate, and/or the like, is referred to as being "on" another element, not only may the element be arranged "directly on" the other element, but another element may be arranged therebetween. In contrast, if (e.g., when) an element is referred to as being "directly on" another element, there are no intervening elements present therebetween.

It will be understood that if (e.g., when) a layer, a region, or a component is referred to as being "connected" to another layer, region, or component, it may be "directly connected" to the other layer, region, or component or may be "indirectly connected" to the other layer, region, or component with other layer, region, or component arranged therebetween. For example, in the present disclosure, if (e.g., when) a layer, a region, or an element is referred to as being electrically connected, it represents a case where the layer, the region, or the element is directly electrically connected and/or a case where the layer, the region, or the element may be indirectly electrically connected with another layer, region, or element arranged therebetween.

The x-axis, the y-axis, and the z-axis are not limited to three axes of the rectangular coordinate system and may be interpreted in a broader sense. For example, the x-axis, the y-axis, and the z-axis may be normal (e.g., substantially perpendicular) to one another or may represent different directions that are not normal (e.g., substantially perpendicular) to one another.

If (e.g., when) a certain embodiment may be implemented differently, a specific process order may be performed in the order different from the described order. As an example, two processes successively described may be concurrently (e.g., simultaneously) performed substantially and performed in the opposite order of the described order.

Sizes of elements in the drawings may be exaggerated or reduced for convenience of explanation. As an example, the size and thickness of each element shown in the drawings may be arbitrarily represented for convenience of description, and thus, embodiments of the present disclosure are not necessarily limited thereto.

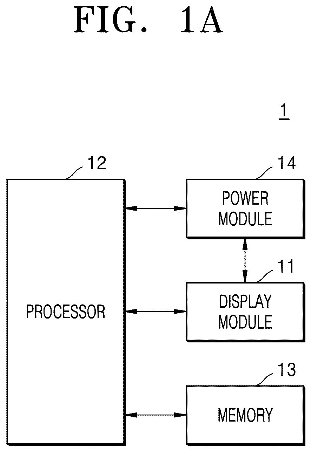

FIG. 1A is a schematic block diagram of an electronic apparatus 1 according to one or more embodiments. The electronic apparatus 1 according to one or more embodiments may include, in addition to a display module 11, a module having another additional function. As an example, as illustrated in FIG. 1A, the electronic apparatus 1 according to one or more embodiments may include the display module 11, a processor 12, a memory 13, and a power module 14.

The processor 12 may be to control elements of the electronic apparatus 1. The processor 12 may include at least one selected from among a central processing unit (CPU), an application processor (AP), a graphic processing unit (GPU), a communication processor (CP), an image signal processor (ISP), and a controller.

The memory 13 may be to store data information desired or required for operations of the processor 12 or the display module 11. If (e.g., when) the processor 12 executes an application stored in the memory 13, data signals for images and/or an input control signal may be transferred to the display module 11, and the display module 11 may process provided signals and output image information.

The power module 14 may include a power supply module, such as a power adapter or a battery unit, and a power converting module to convert power supplied by the power supply module and generate power desired or required for operations of the electronic apparatus 1.

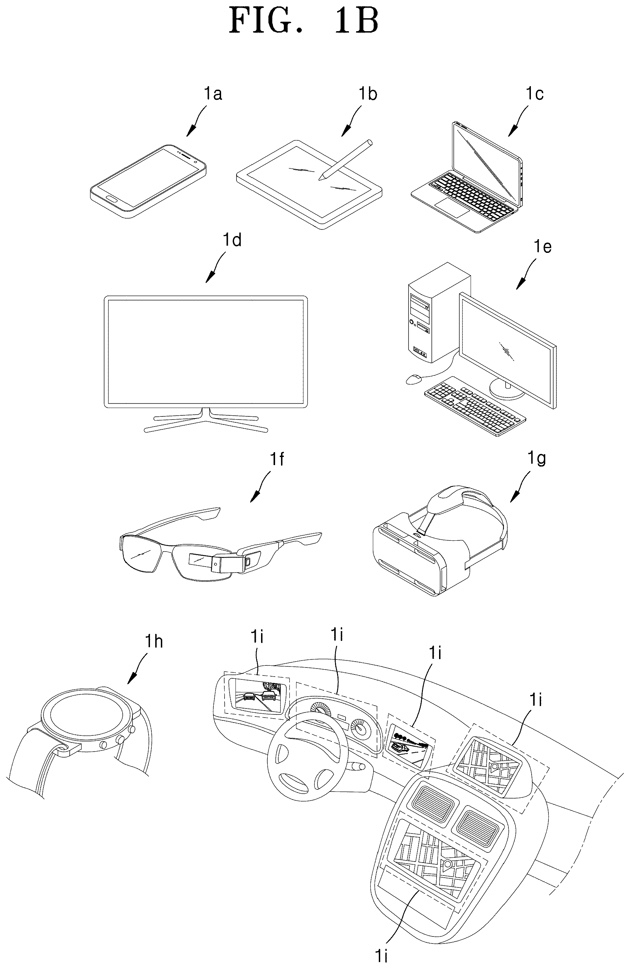

FIG. 1B is a schematic view of the electronic apparatus 1 according to one or more embodiments. Referring to FIG. 1B, the electronic apparatus 1 including the display module 11 may be utilized not only as an electronic apparatus to display images, such as a smartphone 1a, a tablet personal computer (PC) 1b, a laptop 1c, a TV 1d, and a desk monitor 1e, but also as a wearable electronic apparatus including a display module, such as smart glasses 1f, a head mount display 1g, and a smartwatch 1h, and vehicle electronic apparatuses 1i including a display module, such as an instrument panel of an automobile, a center facia, a center information display (CID) arranged on a dashboard, and a room mirror display.

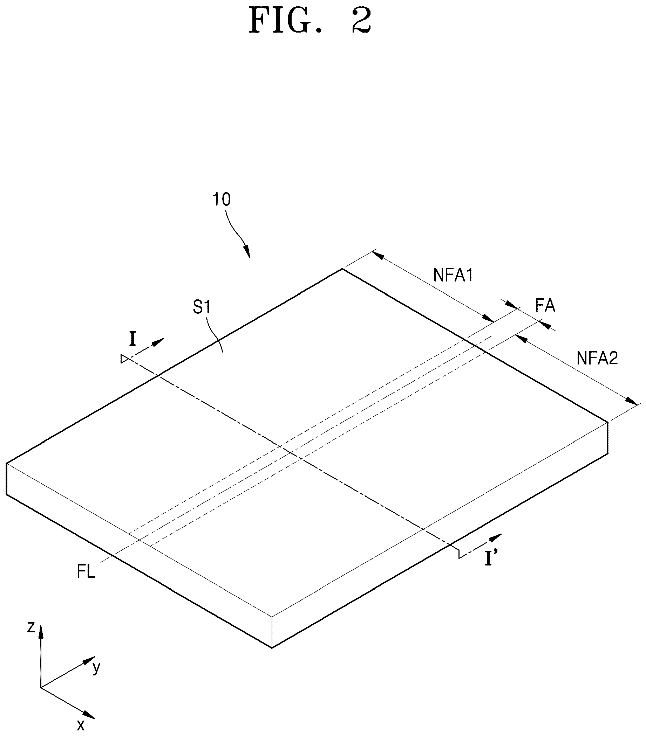

The display module 11 may include a display apparatus 10 (see FIG. 2). The display apparatus 10 may be applicable to one or more suitable electronic apparatuses 1. For example, the electronic apparatus 1 may include the display apparatus 10 and may further include a module or an apparatus having another additional function other than the display apparatus 10. As an example, the electronic apparatus 1 may include the display apparatus 10, the processor 12, the memory 13, and the power module 14, and the display apparatus 10 may be controlled or selected by the processor 12. Hereinafter, the display apparatus 10 is mainly or predominantly described in more detail.

FIG. 2 is a schematic perspective view of the display apparatus 10 according to one or more embodiments. As illustrated in FIG. 2, the display apparatus 10 may have a polygonal shape (e.g., a substantially polygonal shape) including a quadrangle. As an example, the display apparatus 10 may have a rectangular shape (e.g., a substantially rectangular shape) in which a horizontal length thereof is less than a vertical length, a rectangular shape (e.g., a substantially rectangular shape) in which a horizontal length thereof is greater than a vertical length, or a square shape (e.g., a substantially square shape). In one or more embodiments, the display apparatus 10 may have one or more suitable shapes, such as an elliptical shape (e.g., a substantially elliptical shape) or a circular shape (e.g., a substantially circular shape). Although it is illustrated in FIG. 2 that the display apparatus 10 has a rectangular shape (e.g., a substantially rectangular shape) in which a horizontal length is less than a vertical length, embodiments of the present disclosure are not limited thereto.

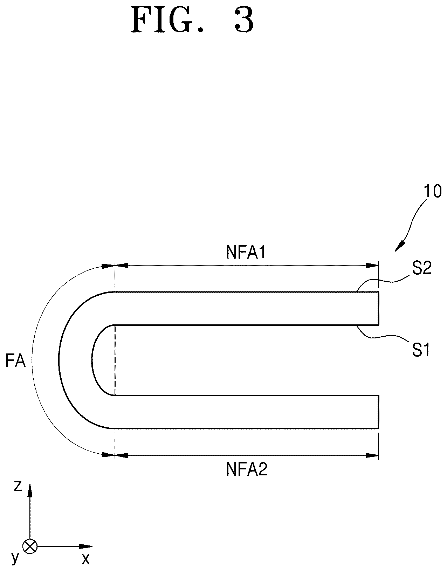

The display apparatus 10 may include a first surface S1 and a second surface S2 (see FIG. 3) opposite to the first surface S1. The display apparatus 10 may be to display images on the first surface S1. For example, the first surface S1 may include a display surface. In one or more embodiments, the first surface S1 may be the upper surface (a +z direction) of the display apparatus 10. The second surface S2 may be a lower surface (a -z direction) of the display apparatus 10. In one or more embodiments, the display apparatus 10 may be to display images also on the second surface S2.

The display apparatus 10 may be folded. For example, at least a portion of the display apparatus 10 may have flexibility, and as the flexible portion is bent, the display apparatus 10 may be folded. As an example, as illustrated in FIG. 3, which is a schematic side view of the display apparatus 10 according to one or more embodiments, the display apparatus 10 may be folded. For example, FIG. 2 is a perspective view of the display apparatus 10 in an unfolded state, and FIG. 3 is a side view of the display apparatus 10 in a folded state.

Accordingly, the display apparatus 10 may include a folding area and an area, for example, a non-folding area, provided to at least one side of the folding area and not folded. In the present disclosure, "non-folding" refers to not folding, and includes not only a case where it is inflexible and rigid and thus does not fold, but also a case where it is flexible but does not fold. The display apparatus 10 may be to display images in not only the non-folding area but also a folding area.

As illustrated in FIG. 2, the display apparatus 10 may include a first non-folding area NFA1, a second non-folding area NFA2, and a foldable area FA. The first non-folding area NFA1 and the second non-folding area NFA2 may be non-folding areas, and the foldable area FA may be an area that is flexible and may be foldable.

The foldable area FA may extend in a direction crossing an imaginary straight line connecting the first non-folding area NFA1 and the second non-folding area NFA2 to each other. For example, if (e.g., when) the display apparatus 10 is unfolded, the first non-folding area NFA1 and the second non-folding area NFA2 may be arranged apart from each other in a first direction (e.g., an x axis direction). The foldable area FA may be arranged between the first non-folding area NFA1 and the second non-folding area NFA2. For example, the first non-folding area NFA1 may be adjacent to one side of the foldable area FA, and the second non-folding area NFA2 may be adjacent to another side of the foldable area FA. If (e.g., when) the display apparatus 10 is unfolded, the foldable area FA may extend in a second direction (e.g., a y axis direction) crossing the first direction.

A folding line FL may be provided inside the foldable area FA in the second direction (e.g., the y axis direction), which is the extension direction of the foldable area FA. Accordingly, the display apparatus 10 may be folded in the foldable area FA. The foldable area FA and the folding line FL of the foldable area FA may overlap a region in which images of the display apparatus 10 are displayed, and if (e.g., when) the display apparatus 10 is folded, a portion that displays images may be folded.

For convenience of description, although it is illustrated in FIG. 2 that the first non-folding area NFA1 and the second non-folding area NFA2 have areas equal or similar to each other, and the display apparatus 10 has one foldable area FA, embodiments of the present disclosure are not limited thereto. As an example, the first non-folding area NFA1 and the second non-folding area NFA2 may have different areas from each other. In one or more embodiments, the display apparatus 10 may include a plurality of foldable areas FA. In this case, the plurality of non-folding areas may be arranged apart from each other, and each of the plurality of foldable areas FA may be arranged between the non-folding areas. Each foldable area FA may be folded with respect to the folding line FL, and the folding line FL may be provided in plurality.

Although it is illustrated in FIG. 2 that the folding line FL passes through the center of the foldable area FA, and the foldable area FA is linearly symmetrical with respect to the folding line FL, embodiments of the present disclosure are not limited thereto. As an example, the folding line FL may be symmetrically (e.g., substantially symmetrically) provided within the foldable area FA.

As illustrated in FIG. 3, the display apparatus 10 may be folded such that the first surface S1 of the first non-folding area NFA1 and the first surface S1 of the second non-folding area NFA2 are opposite to (e.g., face) each other with respect to the folding line FL. For example, because the foldable area FA of the display apparatus 10 is bent, the first surface S1 of the first non-folding area NFA1 and the first surface S1 of the second non-folding area NFA2 may be arranged to be opposite to (e.g., face) each other. Even though the display apparatus 10 is folded, the foldable area FA may extend in a direction crossing an imaginary straight line connecting the first non-folding area NFA1 and the second non-folding area NFA2 to each other. For example, if (e.g., when) the display apparatus 10 is folded, the foldable area FA may extend in the second direction (e.g., the y axis direction) crossing an imaginary straight line (e.g., a straight line parallel to the z axis direction) connecting the first non-folding area NFA1 and the second non-folding area NFA2 to each other. The foldable area FA may be bent and then unfolded again. For example, the display apparatus 10 may be a foldable display apparatus.

The term "folded" in the present disclosure refers to that the shape is not fixed, but is deformed from the original shape into another shape, including being folded, curved, or bent along one or more specific lines, for example, folding lines FL. Accordingly, although it is illustrated in FIG. 3 that the first surface S1 of the first non-folding area NFA1 and the first surface S1 of the second non-folding area NFA2 are arranged to be parallel (e.g., substantially parallel) to each other and folded to be opposite to (e.g., face) each other, embodiments of the present disclosure are not limited thereto. As an example, the first surface S1 of the first non-folding area NFA1 and the first surface S1 of the second non-folding area NFA2 may be folded to form a preset (e.g., set or predetermined) angle (e.g., an acute angle, a right angle, or obtuse angle) with the foldable area FA therebetween.

In one or more embodiments, although it is illustrated in FIG. 3 that the display apparatus 10 is folded, for example, in-folded such that a portion of the first surface S1 and another portion of the first surface S1 are opposite to (e.g., face) each other, embodiments of the present disclosure are not limited thereto. As an example, the display apparatus 10 may be folded, for example, out-folded such that a portion of the second surface S2 and another portion of the second surface S2 are opposite to (e.g., face) each other. For example, if (e.g., when) the display apparatus 10 is folded, the display apparatus 10 may be in-folded such that portions of a display surface are opposite to (e.g., face) each other, or if (e.g., when) the display apparatus 10 is folded, the display apparatus 10 may be out-folded such that the display surface is exposed to the outside. For example, the display apparatus 10 may be folded such that a portion of one surface of the display apparatus 10 and another portion of the one surface of the display apparatus 10 are opposite to (e.g., face) each other. Hereinafter, for convenience of description, the case where the display apparatus 10 is in-folded is mainly or predominantly described in more detail.

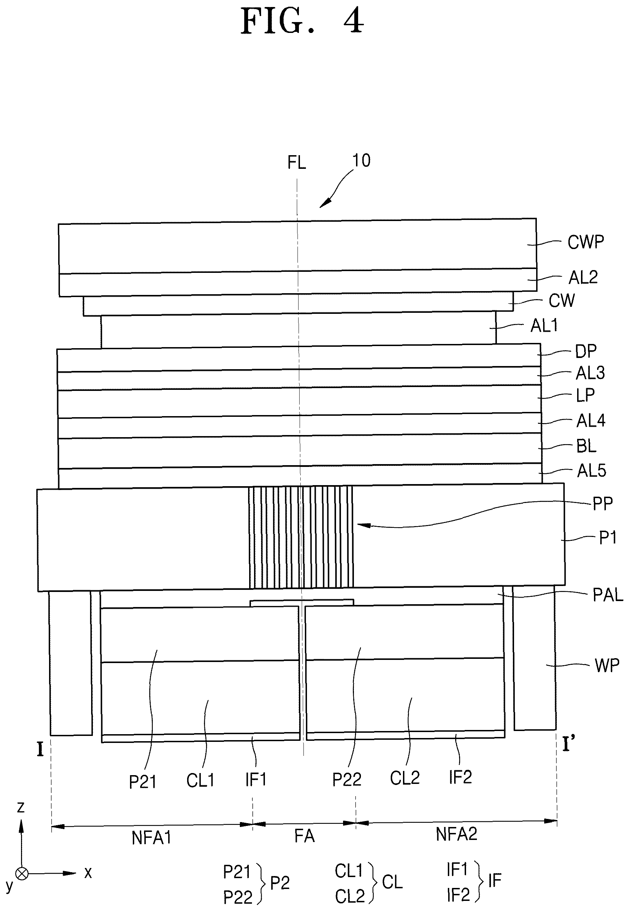

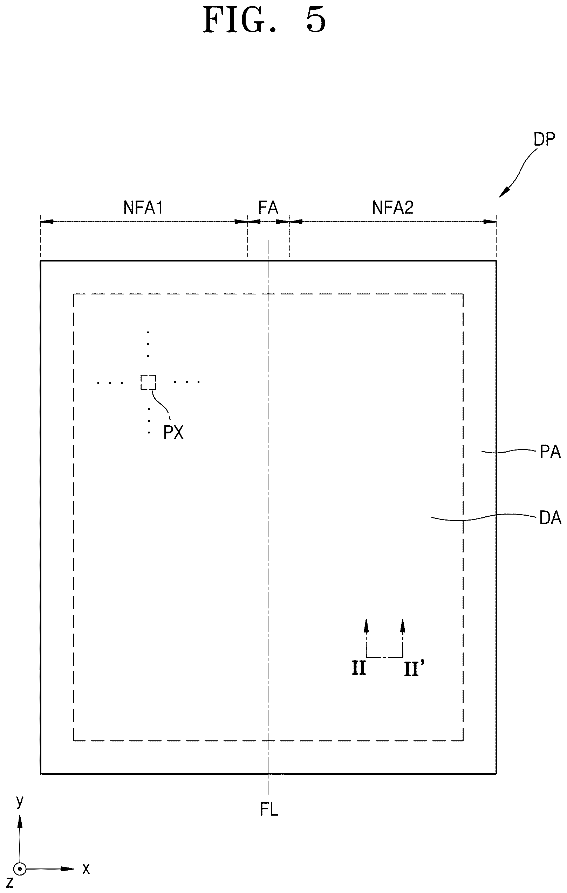

FIG. 4 is a schematic cross-sectional view of the display apparatus 10 of FIG. 2, taken along the line I-I' of FIG. 2. FIG. 5 is a schematic plan view of a portion of a display panel DP in the display apparatus 10 of FIG. 4. As illustrated in FIG. 4, the display apparatus 10 may include the display panel DP, a cover window CW, a window protective layer CWP, a lower protective layer LP, a barrier layer BL, a first plate P1, a second plate P2, a cushion layer CL, and an insulating film IF. For example, the display apparatus 10 may have a structure in which a plurality of elements are stacked. The display apparatus 10 may further include a plurality of adhesive layers, and the adhesive layers may be arranged between the elements of the display apparatus 10 to attach one element to another element. If (e.g., when) needed or desired, the display apparatus 10 may further include one or more suitable elements in addition to the elements shown in FIG. 4.

The display panel DP may be to display images. For example, it may be understood that images displayed by the display apparatus 10 are implemented by the display panel DP. For this purpose, the display panel DP may include a plurality of display elements, and the plurality of display elements may be to emit light. Accordingly, the display panel DP may be to display images through light emitted from the plurality of display elements.

In one or more embodiments, the display element may be an organic light-emitting diode including an organic emission layer. In one or more embodiments, the display element may be a light-emitting diode LED. The size of the light-emitting diode LED may be microscale or nanoscale. As an example, the light-emitting diode may be a micro light-emitting diode. In one or more embodiments, the light-emitting diode may be a nanorod light-emitting diode. The nanorod light-emitting diode may include gallium nitride (GaN). In one or more embodiments, a color-converting layer may be arranged on the nano-rod light-emitting diode. The color-converting layer may include quantum dots. In one or more embodiments, the display element may be a quantum-dot light-emitting diode including a quantum-dot emission layer. In one or more embodiments, the display element may be an inorganic light-emitting diode including an inorganic semiconductor. Elements in the display panel DP are described in more detail.

As described in one or more embodiments, the display apparatus 10 may include the first non-folding area NFA1, the second non-folding area NFA2, and the foldable area FA. Because the display apparatus 10 includes the display panel DP, it may be understood that the display panel DP includes the first non-folding area NFA1, the second non-folding area NFA2, and the foldable area FA. Hereinafter, for convenience of description, the display panel DP may be described to include the first non-folding area NFA1, the second non-folding area NFA2, and the foldable area FA.

For example, if (e.g., when) the display panel DP is unfolded, the first non-folding area NFA1 and the second non-folding area NFA2 may be arranged apart from each other in the first direction (e.g., the x axis direction). The foldable area FA may be arranged between the first non-folding area NFA1 and the second non-folding area NFA2 and may extend in a direction crossing an imaginary straight line connecting the first non-folding area NFA1 and the second non-folding area NFA2 to each other. The folding line FL may be provided inside the foldable area FA in the second direction (e.g., the y axis direction), which is the extension direction of the foldable area FA. Accordingly, the display panel DP may be folded in the foldable area FA.

As illustrated in FIG. 5, the display panel DP may include a display area DA and a peripheral area PA, wherein a plurality of pixels PX are arranged in the display area DA, and the peripheral area PA is outside the display area DA.

Each pixel PX of the display panel DP may be a region that is to emit light of a preset (e.g., set or predetermined) color. The display panel DP may be to display images by using light emitted from the pixels PX. As an example, each pixel PX may be to emit red, green, or blue light. For example, one display element may correspond to one pixel.

The display area DA may be a region that is to provide images, and, as illustrated in FIG. 5, the display area DA may have a polygonal shape (e.g., a substantially polygonal shape) including a quadrangular shape (e.g., a substantially quadrangular shape). As an example, the display area DA may have a rectangular shape (e.g., a substantially rectangular shape) in which a horizontal length thereof is greater than a vertical length, a rectangular shape (e.g., a substantially rectangular shape) in which a horizontal length thereof is less than a vertical length, or a square shape (e.g., a substantially square shape). In one or more embodiments, the display area DA may have one or more suitable shapes, such as an elliptical shape (e.g., a substantially elliptical shape) or a circular shape (e.g., a substantially circular shape).

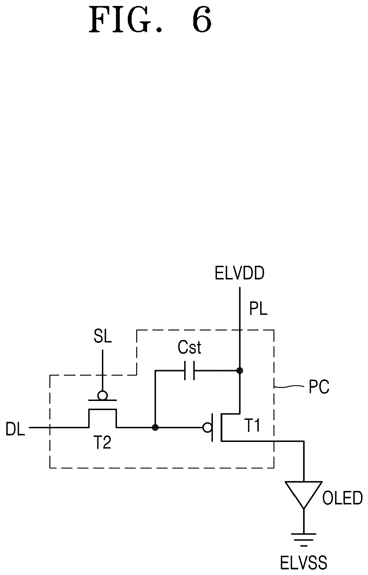

The peripheral area PA may be a non-display area that does not display images and may be around (e.g., surround) the display area DA entirely (e.g., substantially entirely). For example, the pixels PX may not be arranged in the peripheral area PA, and drivers and/or the like to provide electrical signals or power to the pixels PX may be arranged in the peripheral area PA. Pads may be arranged in the peripheral area PA, and electronic elements, a printed circuit board, and/or the like may be electrically connected to the pads. The pads may be arranged apart from each other in the peripheral area PA and electrically connected to a plurality of connection wirings arranged in the peripheral area PA. The connection wirings may electrically connect signal lines, for example, data lines DL (see FIG. 6) (or scan lines SL (see FIG. 6)) arranged in the display area DA and the pads to each other.

The cover window CW may be arranged on the display panel DP. For example, the cover window CW may be arranged on the upper surface (the +z direction) of the display panel DP. Herein, the "upper surface" of the display panel DP may be defined as a surface opposite to (e.g., facing) a direction in which the display panel DP displays images. In one or more embodiments, the cover window CW may be arranged to cover the upper surface of the display panel DP. The cover window CW may be to protect the upper surface of the display panel DP. In one or more embodiments, because the cover window CW forms the exterior of the display apparatus 10, the cover window CW may include a plane and a curved surface corresponding to the shape of the display apparatus 10.

The cover window CW may have a high transmittance to transmit light emitted from the display panel DP and have a small thickness (e.g., may be thin) to reduce the weight of the display apparatus 10. In one or more embodiments, the cover window CW may have high strength and hardness to protect the display panel DP from external impacts. The cover window CW may be a flexible window. The cover window CW may be to protect the display panel DP while easily bending according to external force without occurrence of cracks and/or the like.

The cover window CW may include glass, sapphire, and/or plastic. As an example, the cover window CW may be an ultra-thin tempered glass UTG^{®} whose strength is strengthened by chemical strengthening and/or thermal strengthening and/or a colorless polyimide (CPI). The cover window CW may have a structure in which a flexible polymer layer is arranged on one surface of a glass substrate or include only a polymer layer. Images displayed by the display panel DP may be provided to users through the transparent (e.g., substantially transparent) cover window CW. For example, it may be understood that images displayed by the display apparatus 10 is implemented by the display panel DP.

The window protective layer CWP may be arranged on the cover window CW. The window protective layer CWP may be to protect the cover window CW and prevent scratches from occurring (or reduce a degree to or occurrence of which scratches occur) on the upper surface of the cover window CW. The window protective layer CWP may include a plastic film including a polymer resin. As an example, the window protective layer CWP may include at least one of polymer resins, such as polyethylene terephthalate (PET), poly(butylene terephthalate) (PBT), polycarbonate (PC), polyethylene naphthalate (PEN), polystyrene (PS), polymethylmethacrylate (PMMA), polyvinylchloride (PVC), polyethersulfone (PES), polypropylene (PP), and polyamide (PA).

The lower protective layer LP may be arranged under the display panel DP. The lower protective layer LP may be to protect the display panel DP. As an example, the lower protective layer LP may be to absorb external impacts applied to the lower surface (a -z direction) of the display panel DP. The lower protective layer LP may include a plastic film including a polymer resin. As an example, the lower protective layer LP may include at least one of polymer resins, such as polyethylene terephthalate (PET), poly(butylene terephthalate) (PBT), polycarbonate (PC), polyethylene naphthalate (PEN), polystyrene (PS), polymethylmethacrylate (PMMA), polyvinylchloride (PVC), polyethersulfone (PES), polypropylene (PP), and polyamide (PA).

The barrier layer BL may be arranged under the lower protective layer LP. The barrier layer BL may be to block external foreign substances and/or moisture from penetrating the display panel DP. In one or more embodiments, the barrier layer BL may include an organic insulating (e.g., electrically insulating) material, such as polyethylene terephthalate, polyimide (PI), and/or urethane acrylate.

In one or more embodiments, barrier layer BL may further include a material to block ultraviolet rays (UV). As an example, the barrier layer BL may include a base resin, an ultraviolet absorber, and/or inorganic particles. The ultraviolet absorber and the inorganic particles may be dispersed and provided in the base resin. As an example, the base resin may be an acrylate-base resin, such as urethane acrylate. However, embodiments of the present disclosure are not limited thereto, and a base resin that is optically transparent (e.g., substantially transparent) and may disperse the absorber and the inorganic particles may be used in the barrier layer BL without limitation. As an example, the ultraviolet absorber may include at least one selected from among benzotriazole compounds, benzophenone compounds, salicylic acid compounds, salicylate compounds, cyanoacrylate compounds, cinnamate compounds, oxanilide compounds, polystyrene compounds, azomethine compounds, and triazine compounds.

The first plate P1 may be arranged under the barrier layer BL. The first plate P1 may be arranged under the barrier layer BL to support the display panel DP. Accordingly, because the degree to which the center of the display panel DP sags in the -z direction due to its weight is reduced, the display panel DP may not be easily damaged even if (e.g., when) an external impact is applied.

The first plate P1 may include a folding pattern PP. If (e.g., when) the display apparatus 10 is folded, the shape of the folding pattern PP may vary or the length of the folding pattern PP may vary. Accordingly, the first plate P1 may be more easily folded. As an example, the folding pattern PP may be an opening provided in the first plate P1. In one or more embodiments, the folding pattern PP may be an uneven shape. In one or more embodiments, the folding pattern PP may include links rotatably connected to each other.

The first plate P1 may include at least one selected from among metal, glass, and plastic. In one or more embodiments, the first plate P1 may include polyurethane. In one or more embodiments, the first plate P1 may include carbon fiber reinforced plastic (CFRP). In one or more embodiments, the folding pattern PP may include a material substantially equal to or different from the first plate P1. In one or more embodiments, the first plate P1 may be denoted by a support layer.

The second plate P2 may be arranged under the first plate P1. For example, the second plate P2 may include a second-1 plate P21 and a second-2 plate P22, and the second-1 plate P21 and the second-2 plate P22 may be arranged to be separated from each other around the folding line FL. For example, the second-1 plate P21 and the second-2 plate P22 may be arranged apart from each other with the folding line FL therebetween. For example, at least a portion of the second-1 plate P21 may be arranged under the first non-folding area NFA1, and at least a portion of the second-2 plate P22 may be arranged under the second non-folding area NFA2. The second plate P2 may be to absorb an external impact to protect the display panel DP.

The second plate P2 may be a plate including a metal material. For example, the second plate P2 may include a metal material. The second plate P2 may include metal or an alloy of at least two metals. As an example, the second plate P2 may include aluminium (Al), copper (Cu), iron (Fe), and/or chromium (Cr). However, embodiments of the present disclosure are not limited thereto.

An elastic member may be arranged under a portion of the first plate arranged under the foldable area FA. For example, the elastic member may cover the folding pattern PP. The elastic member may be to improve or enhance the durability of the first plate P1. The elastic member may include thermoplastic polyurethane (TPU).

The cushion layer CL may be arranged under the second plate P2. For example, the cushion layer CL may include a first cushion layer CL1 and a second cushion layer CL2, and the first cushion layer CL1 and the second cushion layer CL2 may be arranged to be separated from each other around the folding line FL. For example, the first cushion layer CL1 and the second cushion layer CL2 may be arranged apart from each other with the folding line FL therebetween. For example, the first cushion layer CL1 may be arranged under the second-1 plate P21, and the second cushion layer CL2 may be arranged under the second-2 plate P22. The cushion layer CL may be to absorb an external impact and prevent the display panel DP from being damaged (or reduce a degree to or occurrence of which the display panel DP is damaged).

The cushion layer CL may include an elastic material. As an example, the cushion layer CL may include a foam including a polymer resin, such as polyurethane, polyethylene, polycarbonate, polypropylene, and/or polyolefin. In one or more embodiments, the cushion layer CL may include an elastic material, such as a sponge formed by a foaming rubber, a urethane-based material, and/or an acrylic-based material. However, the foregoing material is just an example, and the cushion layer CL may include excellent or suitable compressive stress and excellent or suitable shock and vibration absorption properties.

An insulating film IF may be arranged under the cushion layer CL. For example, the insulating film IF may include a first insulating film IF1 and a second insulating film IF2, and the first insulating film IF1 and the second insulating film IF2 may be arranged to be separated from each other around the folding line FL. For example, the first insulating film IF1 and the second insulating film IF2 may be arranged apart from each other with the folding line FL therebetween. For example, the first insulating film IF1 may be arranged under the first cushion layer CL1, and the second insulating film IF2 may be arranged under the second cushion layer CL2. The insulating film IF may be to prevent rattle from occurring (or reduce a degree to or occurrence of which rattle occurs) in the display apparatus 10. The thickness of the insulating film IF may be about 15 µm. However, embodiments of the present disclosure are not necessarily limited thereto.

As described in one or more embodiments, the display apparatus 10 may further include a plurality of adhesive layers, and the adhesive layers may be arranged between the elements of the display apparatus 10 to attach one element to another element. For example, the display apparatus 10 may include a first adhesive layer AL1, a second adhesive layer AL2, a third adhesive layer AL3, a fourth adhesive layer AL4, and a fifth adhesive layer AL5.

The first adhesive layer AL1 is arranged between the display panel DP and the cover window CW. For example, the first adhesive layer AL1 may be in direct contact with the cover window CW. In one or more embodiments, the first adhesive layer AL1 may be in direct contact with the display panel DP. Accordingly, the first adhesive layer AL1 may be arranged to attach the cover window CW to the display panel DP.

The first adhesive layer AL1 includes a cured material of an adhesive composition including a first acrylate-based compound, a second acrylate-based compound, a siloxane-based compound, and a crosslinking agent. For example, the first adhesive layer AL1 may be a material formed by polymerizing a first acrylate-based compound, a second acrylate-based compound, and a crosslinking agent, in which a siloxane-based compound is dispersed. Accordingly, because the first adhesive layer AL1 has a low modulus, the first adhesive layer AL1 may allow the display apparatus 10 to be easily folded and to have excellent or suitable impact resistance. With regard to the cured material of the adhesive composition in the first adhesive layer AL1, the adhesive composition is described herein in more detail.

The second adhesive layer AL2 may be arranged between the cover window CW and the window protective layer CWP. For example, the second adhesive layer AL2 may be in direct contact with the cover window CW and the window protective layer CWP. Accordingly, the second adhesive layer AL2 may be arranged to attach the window protective layer CWP to the cover window CW. The second adhesive layer AL2 may include substantially the same material as the first adhesive layer AL1. As an example, the second adhesive layer AL2 may include a cured material of an adhesive composition including a first acrylate-based compound, a second acrylate-based compound, a siloxane-based compound, and a crosslinking agent.

The third adhesive layer AL3 may be arranged between the display panel DP and the lower protective layer LP. For example, the third adhesive layer AL3 may be in direct contact with the display panel DP and the lower protective layer LP. Accordingly, the third adhesive layer AL3 may be arranged to attach the lower protective layer LP to the display panel DP. The third adhesive layer AL3 may include substantially the same material as the first adhesive layer AL1. As an example, the third adhesive layer AL3 may include a cured material of an adhesive composition including a first acrylate-based compound, a second acrylate-based compound, a siloxane-based compound, and a crosslinking agent.

The fourth adhesive layer AL4 may be arranged between the lower protective layer LP and the barrier layer BL. For example, the fourth adhesive layer AL4 may be in direct contact with the lower protective layer LP and the barrier layer BL. Accordingly, the fourth adhesive layer AL4 may be arranged to attach the barrier layer BL to the lower protective layer LP. The fourth adhesive layer AL4 may include substantially the same material as the first adhesive layer AL1. As an example, the fourth adhesive layer AL4 may include a cured material of an adhesive composition including a first acrylate-based compound, a second acrylate-based compound, a siloxane-based compound, and a crosslinking agent.

The fifth adhesive layer AL5 may be arranged between the barrier layer BL and the first plate P1. For example, the fifth adhesive layer AL5 may be in direct contact with the barrier layer BL and the first plate P1. For example, the fifth adhesive layer AL5 may be arranged to attach the first plate P1 to the barrier layer BL. The fifth adhesive layer AL5 may include substantially the same material as the first adhesive layer AL1. As an example, the fifth adhesive layer AL5 may include a cured material of an adhesive composition including a first acrylate-based compound, a second acrylate-based compound, a siloxane-based compound, and a crosslinking agent.

The display apparatus 10 may include a plate adhesive layer PAL. The plate adhesive layer PAL may be arranged between the first plate P1 and the second plate P2. For example, the plate adhesive layer PAL may be arranged to attach the second plate P2 to the first plate P1. The plate adhesive layer PAL may include, for example, an adhesive member, such as an optically clear (e.g., substantially clear) adhesive OCA and/or a pressure sensitive adhesive PSA.

In one or more embodiments, the display apparatus 10 may further include a water-proof layer WP. In one or more embodiments, the display apparatus 10 may further include a waterproof layer WP. The waterproof layer WP may prevent the elements of the display apparatus 10 from being damaged (or reduce a degree to or occurrence of which the elements of the display apparatus 10 are damaged) by moisture by blocking or absorbing moisture introduced from the outside of the display apparatus 10. In one or more embodiments, the waterproof layer WP may include a tape and/or a sponge.

FIG. 6 is an equivalent circuit diagram of a pixel circuit PC in the display panel DP of FIG. 5. The pixel circuit PC may be electrically connected to a display element, and one display element may correspond to one pixel PX. FIG. 6 illustrates an organic light-emitting diode OLED as the display element. In one or more embodiments, the display element may be to emit red, green, or blue light.

The pixel circuit PC may include a first transistor T1, a second transistor T2, and a storage capacitor Cst. The second transistor T2 may be a switching thin-film transistor, may be connected to a scan line SL and a data line DL, and may be arranged to be turned on according to a switching signal and transfer a data signal to the first transistor T1, the data signal being input from the data line DL, and the switching signal being input from the scan line SL. The storage capacitor Cst may include one end electrically connected to the second transistor T2 and another end electrically connected to a driving voltage line PL. The storage capacitor Cst may be to store a voltage corresponding to a difference between a voltage transferred from the second transistor T2 and a driving power voltage ELVDD supplied to the driving voltage line PL.

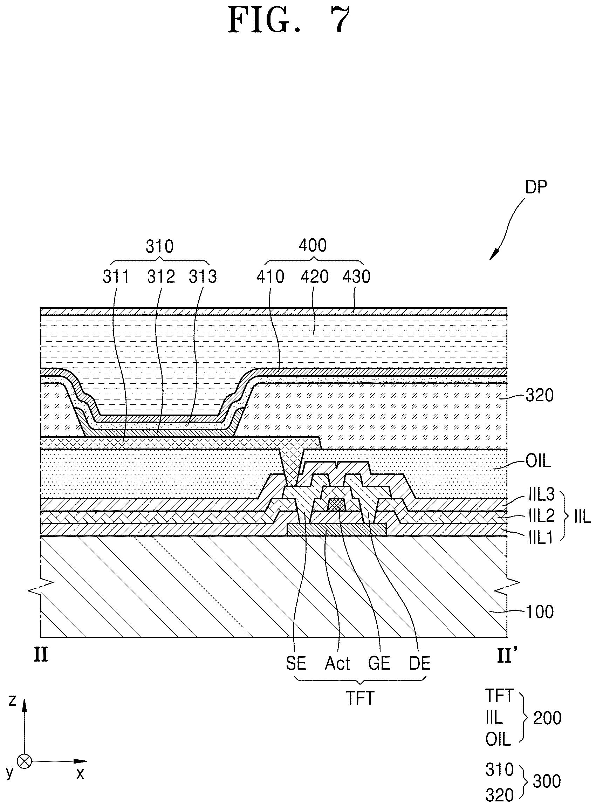

The first transistor T1 may be a driving transistor, may be connected to the driving voltage line PL and the storage capacitor Cst, and may be arranged to control the magnitude of a driving current according to the voltage stored in the storage capacitor Cst, the driving current flowing from the driving voltage line PL to the organic light-emitting diode OLED. The organic light-emitting diode OLED may be to emit light having a preset (e.g., set or predetermined) brightness corresponding to the driving current. An opposite electrode 313 (see FIG.7) of the organic light-emitting diode OLED may be to receive an electrode power voltage ELVSS.

Although it is described with reference to FIG. 6 that the pixel circuit PC includes two transistors and one storage capacitor, embodiments of the present disclosure are not limited thereto. As an example, the number of transistors and the number of storage capacitors may be suitably changed according to the design of the pixel circuit PC.

FIG. 7 is a schematic cross-sectional view of the display panel DP of FIG. 5, taken along the line II-II' of FIG. 5. As illustrated in FIG. 7, the display panel DP may include a substrate 100, a pixel circuit layer 200, a display element layer 300, and an encapsulation layer 400.

The substrate 100 may include glass, metal, and/or a polymer resin. The substrate 100 needs or is desired to be flexible or bendable. In this case, the substrate 100 may include a polymer resin, such as polyethersulfone, polyacrylate, polyetherimide, polyethylene naphthalate, polyethylene terephthalate, polyphenylene sulfide, polyarylate, polyimide, polycarbonate, and/or cellulose acetate propionate. The substrate 100 may have a multi-layered structure including two layers each including the polymer resin, and a barrier layer including an inorganic material (such as silicon oxide (e.g., SiO_{X}, wherein 0 < x ≤ 2; e.g., SiO₂), silicon nitride (e.g., SiNₓ, wherein 0 < x ≤ 2; e.g., Si₃N₄), and/or silicon oxynitride (e.g., SiOₓN_{y}, wherein 0 < x ≤ 2 and 0 ≤ y ≤ 2; e.g., SiON or Si₂N₂O)) therebetween. However, one or more suitable modifications may be made.

The pixel circuit layer 200 may be arranged on the substrate 100. The pixel circuit layer 200 may include a transistor TFT, an inorganic insulating layer IIL, and an organic insulating layer OIL. The transistor TFT may include a semiconductor layer Act, a gate electrode GE, a source electrode SE, and a drain electrode DE. The inorganic insulating layer IIL may include a gate insulating layer IIL1, a first interlayer insulating layer IIL2, and a second interlayer insulating layer IIL3. For convenience of illustration, one transistor TFT is illustrated in FIG. 7, and the transistor TFT may correspond to the first transistor T1 (see FIG. 6).

The semiconductor layer Act may be arranged on the substrate 100. The semiconductor layer Act may include polycrystalline silicon. In one or more embodiments, the semiconductor layer Act may include amorphous (e.g., non-crystalline) silicon, an oxide semiconductor, and/or an organic semiconductor. In one or more embodiments, the semiconductor layer Act may include a channel region, a drain region, and a source region, the drain region and the source region being on two opposite sides of the channel region.

The gate insulating layer IIL1 may be arranged on the semiconductor layer Act and the substrate 100. The gate insulating layer IIL1 may include an inorganic insulating (e.g., electrically insulating) material, such as silicon oxide (e.g., SiO_{X}, wherein 0 < x ≤ 2; e.g., SiO₂), silicon nitride (e.g., SiNₓ, wherein 0 < x ≤ 2; e.g., Si₃N₄), and/or silicon oxynitride (e.g., SiOₓN_{y}, wherein 0 < x ≤ 2 and 0 ≤ y ≤ 2; e.g., SiON or Si₂N₂O). As an example, the gate insulating layer IIL1 may have a single-layered structure or a multi-layered structure including the foregoing materials. The insulating layer including the inorganic insulating material may be formed through chemical vapor deposition. This may also be applicable to one or more embodiments and modifications thereof.

Although it is illustrated in FIG. 7 that the gate insulating layer IIL1 has a shape corresponding to the entire surface of the substrate 100 and has a structure in which contact holes are formed in a preset (e.g., set or predetermined) portion, embodiments of the present disclosure are not limited thereto. As an example, the gate insulating layer IIL1 may be patterned in substantially the same shape as the shape of the gate electrode GE.

The gate electrode GE may be arranged on the gate insulating layer IIL1. For example, because the gate insulating layer IIL1 is arranged between the semiconductor layer Act and the gate electrode GE, insulation (e.g., electrical insulation) between the semiconductor layer Act and the gate electrode GE may be secured. The gate electrode GE may overlap the channel region of the semiconductor layer Act. The gate electrode GE may include a low-resistance (e.g., low electrical resistance) metal material. In one or more embodiments, the gate electrode GE may include a conductive (e.g., electrically conductive) material including molybdenum (Mo), aluminium (Al), copper (Cu), and/or titanium (Ti) and have a single-layered structure or a multi-layered structure including the foregoing conductive materials.

The first interlayer insulating layer IIL2 may be arranged on the gate electrode GE and the gate insulating layer IIL1. The first interlayer insulating layer IIL2 may include an inorganic insulating (e.g., electrically insulating) material, such as silicon oxide (e.g., SiO_{X}, wherein 0 < x ≤ 2; e.g., SiO₂), silicon nitride (e.g., SiNₓ, wherein 0 < x ≤ 2; e.g., Si₃N₄), and/or silicon oxynitride (e.g., SiOₓN_{y}, wherein 0 < x ≤ 2 and 0 ≤ y ≤ 2; e.g., SiON or Si₂N₂O). As an example, the first interlayer insulating layer IIL2 may have a single-layered structure or a multi-layered structure including the foregoing materials.

The source electrode SE and the drain electrode DE may be arranged on the first interlayer insulating layer IIL2. Each of the source electrode SE and the drain electrode DE may be connected to the semiconductor layer Act through a contact hole in the first interlayer insulating layer IIL2. At least one selected from the source electrode SE and the drain electrode DE may include a conductive (e.g., electrically conductive) material including molybdenum (Mo), aluminium (Al), copper (Cu), and/or titanium (Ti) and include a single-layered structure or a multi-layered structure including the foregoing conductive materials. In one or more embodiments, at least one selected from the source electrode SE and the drain electrode DE may have a multi-layered structure of Ti/Al/Ti.

However, embodiments of the present disclosure are not limited thereto. As an example, the transistor TFT may have only one selected from the source electrode SE and the drain electrode DE or have neither of them. As an example, one transistor TFT may not have a drain electrode DE, another transistor TFT connected to the transistor TFT may not have a source electrode SE, and semiconductor layers Act of the two transistors may be connected to each other. This connection structure may bring about substantially the same effect as if (e.g., when) one transistor TFT has a source electrode SE and another transistor TFT has a drain electrode DE, and the source electrode SE of one transistor TFT is connected to the drain electrode DE of the other transistor TFT.

The second interlayer insulating layer IIL3 may be arranged on the source electrode SE, the drain electrode DE, and the first interlayer insulating layer IIL2. The second interlayer insulating layer IIL3 may include an inorganic insulating (e.g., electrically insulating) material, such as silicon oxide (e.g., SiO_{X}, wherein 0 < x ≤ 2; e.g., SiO₂), silicon nitride (e.g., SiNₓ, wherein 0 < x ≤ 2; e.g., Si₃N₄), and/or silicon oxynitride (e.g., SiOₓN_{y}, wherein 0 < x ≤ 2 and 0 ≤ y ≤ 2; e.g., SiON or Si₂N₂O). As an example, the second interlayer insulating layer IIL3 may have a single-layered structure or a multi-layered structure including the foregoing materials.

The organic insulating layer OIL may be arranged on the second interlayer insulating layer IIL3. The organic insulating layer OIL may generally planarize the upper portion of the pixel circuit layer 200. The organic insulating layer OIL may include an organic material, for example, acryl, benzocyclobutene (BCB), and/or hexamethyldisiloxane (HMDSO). Although it is illustrated in FIG. 7 that the organic insulating layer OIL is a single layer, the organic insulating layer OIL may be a multilayer. However, one or more suitable modifications may be made.

The display element layer 300 may be arranged on the pixel circuit layer 200. The display element layer 300 may include a display element 310 and a pixel-defining layer 320. The display element 310 may be electrically connected to the transistor TFT. The display element 310 may be an organic light-emitting diode including, for example, a pixel electrode 311, an opposite electrode 313, and an emission layer 312, wherein the emission layer 312 is arranged between the pixel electrode 311 and the opposite electrode 313. If (e.g., when) the display element 310 is electrically connected to the transistor TFT, it may be understood that the pixel electrode 311 of the organic light-emitting diode is electrically connected to the transistor TFT.

The pixel electrode 311 may be electrically connected to the transistor TFT by being in contact with one selected from the source electrode SE and the drain electrode DE through a contact hole in the second interlayer insulating layer IIL3 and the organic insulating layer OIL. The pixel electrode 311 may include a conductive (e.g., electrically conductive) oxide, such as indium tin oxide (ITO), indium zinc oxide (IZO), zinc oxide (e.g., ZnOₓ, wherein 0 < x ≤ 2; e.g., ZnO), indium oxide (e.g., In₂O₃), indium gallium oxide (IGO), and/or aluminium zinc oxide (AZO). In one or more embodiments, the pixel electrode 311 may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a (e.g., any suitable) compound thereof. In one or more embodiments, the pixel electrode 311 may further include a layer on/under the reflective layer, the layer including ITO, IZO, ZnO, and/or In₂O₃.

The pixel-defining layer 320 may cover the edge of the pixel electrode 311. The pixel-defining layer 320 may include a pixel opening, and the pixel opening may overlap the pixel electrode 311. As an example, the pixel opening may expose the central portion of the pixel electrode 311, and at least a portion of the emission layer 312 of the display element 310 may be positioned in the pixel opening. An emission area of light emitted from the display element 310 may be defined by the pixel opening.

In one or more embodiments, in a case illustrated in FIG. 7, the pixel-defining layer 320 may increase a distance between the edge of the pixel electrode 311 and the opposite electrode 313 over the pixel electrode 311. Accordingly, arcs and/or the like may be prevented from occurring at the edges of the pixel electrode 311 (or a degree to or occurrence of which arcs and/or the like occur at the edges of the pixel electrode 311 may be reduced). The pixel-defining layer 320 may include an organic insulating (e.g., electrically insulating) material, such as polyimide and/or HMDSO. In one or more embodiments, the pixel-defining layer 320 may include a light-blocking material.

The opposite electrode 313 may be arranged over the pixel electrode 311. The opposite electrode 313 may be integrally provided over the entire surface of the substrate 100, and accordingly, commonly provided over the plurality of display elements 310. For example, the opposite electrode 313 may be integrally provided over the plurality of display elements 310. Accordingly, the opposite electrode 313 may correspond to a plurality of pixel electrodes 311. The opposite electrode 313 may include a light-transmissive conductive (e.g., electrically conductive) layer including ITO, In₂O₃, and/or IZO, and include a semi-transmissive layer including metal, such as aluminium (Al) and/or silver (Ag). As an example, the opposite electrode 313 may be a semi-transmissive layer including magnesium (Mg) and/or silver (Ag).

The emission layer 312 that may be to emit light may be arranged between the pixel electrode 311 and the opposite electrode 313. The emission layer 312 may be to emit red, green, or blue light. The emission layer 312 may include a high-molecular weight organic material (e.g., a polymer organic material) and/or a low-molecular weight organic material that may be to emit light having a preset (e.g., set or predetermined) color (red, green, or blue). As an example, the emission layer 312 may include a polymer material, such as a polyphenylene vinylene (PPV)-based material and a polyfluorene-based material. The emission layer 312 may be formed by screen printing, inkjet printing, laser induced thermal imaging (LITI), and/or the like. However, embodiments of the present disclosure are not limited thereto.

In one or more embodiments, a functional layer may be arranged under and on the emission layer 312. The functional layer may include a hole injection layer (HIL), a hole transport layer (HTL), an electron transport layer (ETL), and/or an electron injection layer (EIL). The functional layer may be integrally provided over the plurality of pixel electrodes 311 or be patterned to correspond to each of the plurality of pixel electrodes 311.

Because the display element 310 may be easily damaged by external moisture, oxygen, and/or the like, the encapsulation layer 400 may be to protect the display element 310 by covering the display element 310. As illustrated in FIG. 7, the encapsulation layer 400 may include a first inorganic encapsulation layer 410, an organic encapsulation layer 420, and a second inorganic encapsulation layer 430.

The first inorganic encapsulation layer 410 may cover the opposite electrode 313 and may include silicon oxide (e.g., SiO_{X}, wherein 0 < x ≤ 2; e.g., SiO₂), silicon nitride (e.g., SiNₓ, wherein 0 < x ≤ 2; e.g., Si₃N₄), and/or silicon oxynitride (e.g., SiOₓN_{y}, wherein 0 < x ≤ 2 and 0 ≤ y ≤ 2; e.g., SiON or Si₂N₂O). If (e.g., when) needed or desired, other layers including a capping layer may be arranged between the first inorganic encapsulation layer 410 and the opposite electrode 313. Because the first inorganic encapsulation layer 410 is formed along a structure thereunder, the upper surface of the first inorganic encapsulation layer 410 may not be flat as illustrated in FIG. 7. The organic encapsulation layer 420 may cover the first inorganic encapsulation layer 410 and, unlike the first inorganic encapsulation layer 410, the upper surface of the organic encapsulation layer 420 may be approximately or substantially flat. The organic encapsulation layer 420 may include at least one material selected from among polyethylene terephthalate, polyethylene naphthalate, polycarbonate, polyimide, polyethylene sulfonate, polyoxymethylene, polyarylate, and hexamethyldisiloxane. The second inorganic encapsulation layer 430 may cover the opposite electrode 313 and may include silicon oxide (e.g., SiO_{X}, wherein 0 < x ≤ 2; e.g., SiO₂), silicon nitride (e.g., SiNₓ, wherein 0 < x ≤ 2; e.g., Si₃N₄), and/or silicon oxynitride (e.g., SiOₓN_{y}, wherein 0 < x ≤ 2 and 0 ≤ y ≤ 2; e.g., SiON or Si₂N₂O).

Because the encapsulation layer 400 includes the first inorganic encapsulation layer 410, the organic encapsulation layer 420, and the second inorganic encapsulation layer 430, even if (e.g., when) cracks occur inside the encapsulation layer 400, the cracks may not be connected between the first inorganic encapsulation layer 410 and the organic encapsulation layer 420 or between the organic encapsulation layer 420 and the second inorganic encapsulation layer 430 through the above multi-layered structure. With this configuration or arrangement, forming of a path through which external moisture and/or oxygen penetrates the inside of the display panel DP may be prevented or reduced.

Hereinafter, the adhesive composition to form the first adhesive layer AL1 is described in more detail. As described in one or more embodiments, the first adhesive layer AL1 is a cured material of an adhesive composition including a first acrylate-based compound, a second acrylate-based compound, a siloxane-based compound, and a crosslinking agent. The adhesive composition may be an acrylate-based adhesive composition. In the present disclosure, an acrylate-based adhesive composition refers to an adhesive composition including acrylate and/or an acrylate derivative.

The first acrylate-based compound includes an acryloyl group. For example, the first acrylate-based compound may be a monomer and/or polymer having one acryloyl group at the terminal of the molecule. As an example, the first acrylate-based compound may include a first acrylate-based monomer having an acryloyl group and a polymer obtained by polymerizing the first acrylate-based monomer. The first acrylate-based monomer may include at least one selected from among 2-ethylhexyl acrylate, butyl acrylate, and ethyl acrylate.

The second acrylate-based compound includes an acryloyl group and is different from the first acrylate-based compound. For example, the second acrylate-based compound may have one acryloyl group at the terminal of the molecule, and the second acrylate-based compound further includes at least one selected from among a carboxyl group, a hydroxyl group, an amide group, an amino group, and an epoxy group. For example, the second acrylate-based compound includes an acryloyl group and at least one selected from among a carboxyl group, a hydroxyl group, an amide group, an amino group, and an epoxy group. Because the second acrylate-based compound further includes at least one selected from among a carboxyl group, a hydroxyl group, an amide group, an amino group, and an epoxy group, the adhesive strength of the cured material of the adhesive composition may be improved or enhanced.

For example, the second acrylate-based compound may include at least one selected from among acrylic acid, carboxy ethyl acrylate, carboxy propyl acrylate, carboxy butyl acrylate, hydroxy ethyl acrylate, n-hydroxy propyl acrylate, n-hydroxy butyl acrylate, acrylamide, n-diethyl acrylamide, dimethylaminoethyl acrylate, diethylaminoethyl acrylate, dimethylaminopropyl acrylate, and glycidyl acrylate.

Carboxy ethyl acrylate may be 3-(acryloyloxy)propanoic acid. Carboxy propyl acrylate may be 4-(acryloyloxy)butanoic acid. Carboxy butyl acrylate may be 5-(acryloyloxy)pentanoic acid.

Hydroxy ethyl acrylate may be 2-hydroxyethyl acrylate. n-Hydroxy propyl acrylate may be 3-hydroxypropyl acrylate. n-Hydroxy butyl acrylate may be 4-hydroxybutyl acrylate.

n-Diethyl acrylamide may be N,N-diethylacrylamide. Dimethylaminoethyl acrylate may be 2-(dimethylamino)ethyl acrylate. Diethylaminoethyl acrylate may be 2-(diethylamino)ethyl acrylate. Dimethylaminopropyl acrylate may be 3-(dimethylamino)propyl acrylate.

The siloxane-based compound includes a siloxane group. A siloxane group is a functional group consisting of (e.g., including) two silicon atoms bonded to one oxygen atom (e.g., Si-O-Si). The siloxane-based compound may be an organosilicon compound including such a siloxane group, for example, an organosiloxane compound. The siloxane-based compound may improve or enhance the impact resistance of the display apparatus including a cured material of the adhesive composition without excessively (or substantially) increasing the repulsive force of the display apparatus including the cured material of the adhesive composition.

In one or more embodiments, a portion derived from a siloxane-based compound among the cured material of the adhesive composition may form a hydrogen bond with a portion derived from a second acrylate-based compound among the cured material of the adhesive composition. Accordingly, the dispersibility of the portion derived from the siloxane-based compound in the cured material of the adhesive composition may be improved or enhanced.

For example, the siloxane-based compound may include at least one selected from among polydimethylsiloxane, polymethylphenylsiloxane, and polydiphenylsiloxane.

The crosslinking agent may include an acryloyl group and may be different from the first acrylate-based compound and the second acrylate-based compound. For example, the crosslinking agent may have at least two acryloyl groups. For example, the crosslinking agent may include at least one selected from 1,6-hexanediol diacrylate and dipentaerythritol hexaacrylate.

In one or more embodiments, the adhesive composition may include about 70 wt% to about 80 wt% of the first acrylate-based compound, about 10 wt% to about 20 wt% of the second acrylate-based compound, about 1 wt% to about 10 wt% of the siloxane-based compound, and about 0.1 wt% to about 3 wt% of the crosslinking agent. In the present disclosure, the content (e.g., amount) of each component in the adhesive composition may be a value expressed based on the total sum of the weight of the first acrylate-based compound, the weight of the second acrylate-based compound, the weight of the siloxane-based compound, and the weight of the crosslinking agent. For example, the content (e.g., amount) of each component in the adhesive composition may be a value expressed on the premise that the total weight of the first acrylate-based compound, the second acrylate-based compound, the siloxane-based compound, and the crosslinking agent is 100 weight% (wt%).

For example, if (e.g., when) the total weight of the first acrylate-based compound, the second acrylate-based compound, the siloxane-based compound, and the crosslinking agent in the adhesive composition is 100 wt%, the adhesive composition may include about 70 wt% to about 80 wt% of the first acrylate-based compound, about 10 wt% to about 20 wt% of the second acrylate-based compound, about 1 wt% to about 10 wt% of the siloxane-based compound, and about 0.1 wt% to about 3 wt% of the crosslinking agent. The content (e.g., amount) of each component in the adhesive composition may be results analyzed using nuclear magnetic resonance spectroscopy (NMR spectroscopy). Nuclear magnetic resonance spectroscopy is a method of measuring the sample to be analyzed by using radio frequency (RF) resonance that causes rotational transitions in atomic nuclei.

The first adhesive layer AL1 is formed by curing the adhesive composition. For example, the first adhesive layer AL1 may be formed by photocuring the adhesive composition. For example, the first adhesive layer AL1 may be formed by applying an adhesive composition onto the display panel DP using a method, such as slit coating, spin coating, and/or inkjet printing, and irradiating ultraviolet rays to the applied adhesive composition. For example, ultraviolet rays having a light intensity of about 1,000 mJ/cm² to about 3,000 mJ/cm² may be irradiated to the adhesive composition applied on the display panel DP. For example, ultraviolet rays having a light intensity of about 2,000 mJ/cm² may be irradiated to the adhesive composition applied on the display panel DP. Ultraviolet rays having a wavelength of about 300 nm to about 400 nm may be used for photocuring. A light-emitting diode (LED) and/or metal halide may be used as an ultraviolet source. However, embodiments of the present disclosure are not necessarily limited thereto.

In this case, the first adhesive layer AL1 may allow the display apparatus 10 to have a low repulsive force. In the present disclosure, the repulsive force refers to the force that causes the display apparatus 10 to unfold if (e.g., when) the display apparatus 10 is folded. For example, if (e.g., when) the repulsive force of the display apparatus 10 is low, folding of the display apparatus 10 may be easy. However, if (e.g., when) the repulsive force of the display apparatus 10 is high, folding of the display apparatus 10 may not be easy.

In one or more embodiments, the display apparatus 10 including the first adhesive layer AL1 may have excellent or suitable impact resistance. Because the first adhesive layer AL1 includes the adhesive composition, the first adhesive layer AL1 includes the siloxane-based compound. Generally, to improve or enhance the impact resistance of the display apparatus, the display apparatus includes an adhesive layer in which silica particles are dispersed. Similar to the silica particles, the siloxane-based compound of the first adhesive layer AL1 may improve or enhance the impact resistance of the display apparatus 10. Accordingly, the display apparatus 10 including the first adhesive layer AL1 may have excellent or suitable impact resistance. Accordingly, the display apparatus 10 according to one or more embodiments may be easily folded and may have an excellent or suitable impact resistance.

In one or more embodiments, the adhesive composition may further include a photopolymerization initiator. The photopolymerization initiator may promote photocuring of the adhesive composition. For example, the photopolymerization initiator may be benzophenone or a derivative thereof, anthraquinone or a derivative thereof, and/or benzoin or a derivative thereof. However, embodiments of the present disclosure are not necessarily limited thereto, and any suitable material that is generally used as a photopolymerization initiator may be used.

### Experimental Examples

Hereinafter, one or more embodiments of the present disclosure are described in more detail through Experimental Example. However, Experimental Examples are intended to explain the disclosure in more detail, and the scope of the present disclosure is not limited by Experimental Examples. Experimental examples may be appropriately or suitably modified and changed by those of ordinary skilled in the art within the scope of the disclosure. Experimental Examples may differ only in the components and contents (e.g., amounts) of the adhesive composition of the first adhesive layer, and other conditions may each independently be substantially the same.

Table 1 shows the components and the contents (e.g., amounts) of the adhesive composition to form the first adhesive layer of the display apparatus according to one or more embodiments. For example, Table 1 shows the components and the contents (e.g., amounts) of the adhesive composition of the first adhesive layer of Embodiment 1.

**Table 1**

| Component | Content (wt%) |
|---|---|
| 2-Ethylhexyl acrylate | 78 |
| Acrylic acid | 16 |
| Polydimethylsiloxane | 5 |
| 1,6-Hexanediol diacrylate | 1 |

Referring to Table 1, the adhesive composition of the first adhesive layer of Embodiment 1 includes a first acrylate-based compound, a second acrylate-based compound, a siloxane-based compound, and a crosslinking agent. For example, the adhesive composition of the first adhesive layer of Embodiment 1 includes 2-ethylhexyl acrylate as the first acrylate-based compound and includes acrylic acid as the second acrylate-based compound. The adhesive composition of the first adhesive layer of Embodiment 1 includes polydimethylsiloxane as a siloxane-based compound and includes 1,6-hexanediol diacrylate as a crosslinking agent. For example, the adhesive composition of the first adhesive layer of Embodiment 1 includes about 78 wt% of 2-ethylhexyl acrylate, about 16 wt% of acrylic acid, about 5 wt% of polydimethylsiloxane, and about 1 wt% of 1,6-hexanediol diacrylate.

Table 2 shows the components and the contents (e.g., amounts) of the adhesive composition of the first adhesive layer of the display apparatus according to Comparative Example 1. For example, Table 2 shows the components and the contents (e.g., amounts) of the adhesive composition of the first adhesive layer of Comparative Example 1.

**Table 2**

| Component | Content (wt%) |
|---|---|
| 2-Ethylhexyl acrylate | 92 |
| Silica | 7 |
| 1,6-Hexanediol diacrylate | 1 |

Referring to Table 2, the adhesive composition of the first adhesive layer of Comparative Example 1 includes a first acrylate-based compound and a crosslinking agent, but does not include a second acrylate-based compound and a siloxane-based compound. However, the adhesive composition of the first adhesive layer of Comparative Example 1 further includes silica particles. Silica in the adhesive composition of the first adhesive layer of Comparative Example 1 has a diameter of about 10 nm to about 100 nm. For example, the adhesive composition of the first adhesive layer of Comparative Example 1 includes 2-ethylhexyl acrylate as the first acrylate-based compound and includes 1,6-hexanediol diacrylate as a crosslinking agent. The adhesive composition of the first adhesive layer of Comparative Example 1 includes silica particles. For example, the adhesive composition of the first adhesive layer of Comparative Example 1 includes about 92 wt% of 2-ethylhexyl acrylate, about 7 wt% of silica, and about 1 wt% of 1,6-hexanediol diacrylate.

Tables 3 and 4 show the repulsive force of the display apparatuses according to Embodiment 1 and Comparative Example 1. For example, the first adhesive layer of Embodiment 1 was manufactured by photocuring an adhesive composition having the components and contents (e.g., amounts) of Table 1, and the first adhesive layer of Comparative Example 1 was manufactured by photocuring an adhesive composition having the components and contents (e.g., amounts) of Table 2. For example, ultraviolet rays having a light intensity of about 2,000 mJ/cm² were irradiated to the adhesive composition applied on the display panel for about 10 seconds. Ultraviolet rays with a wavelength of about 300 nm were used for photocuring, and LEDs were used as the ultraviolet source.

Embodiment 1 and Comparative Example 1 differ only in the first adhesive layer, and all other components are substantially the same except for the first adhesive layer. The repulsive force was measured by measuring the extent to which the display apparatus, having substantially the same structure as the structure described in one or more embodiments with reference to FIG. 4, was folded to the maximum using a jig (e.g., folded so that (e.g., such that) the first non-folding area was parallel (e.g., substantially parallel) to the second non-folding area), and then the display apparatus was unfolded. The repulsive force was measured at different measurement temperatures, about 25 °C and about -10 °C, and the unit of repulsive force is Newton (N).

Table 3 shows the repulsive force when the thickness of the first adhesive layer is about 50 µm, and Table 4 shows the repulsive force when the thickness of the first adhesive layer is about 75 µm.

**Table 3**

| | Comparative Example 1 | Embodiment 1 |
|---|---|---|
| 25 °C | 1.73 N | 1.66 N |
| -10 °C | 3.22 N | 3.08 N |

**Table 4**

| | Comparative Example 1 | Embodiment 1 |
|---|---|---|
| 25 °C | 2.04 N | 1.87 N |
| -10 °C | 3.35 N | 3.24 N |

Referring to Table 3, when the thickness of the first adhesive layer is about 50 µm, Comparative Example 1 has a repulsive force of about 1.73 N at about 25 °C and a repulsive force of about 3.22 N at about -10 °C. When the thickness of the first adhesive layer is about 50 µm, Embodiment 1 has a repulsive force of about 1.66 N at about 25 °C and a repulsive force of about 3.08 N at about -10 °C.

Referring to Table 4, when the thickness of the first adhesive layer is about 75 µm, Comparative Example 1 has a repulsive force of about 2.04 N at about 25 °C and a repulsive force of about 3.35 N at about -10 °C. When the thickness of the first adhesive layer is about 75 µm, Embodiment 1 has a repulsive force of about 1.87 N at about 25 °C and a repulsive force of about 3.24 N at about -10 °C. For example, Embodiment 1 has a lower repulsive force than Comparative Example 1.

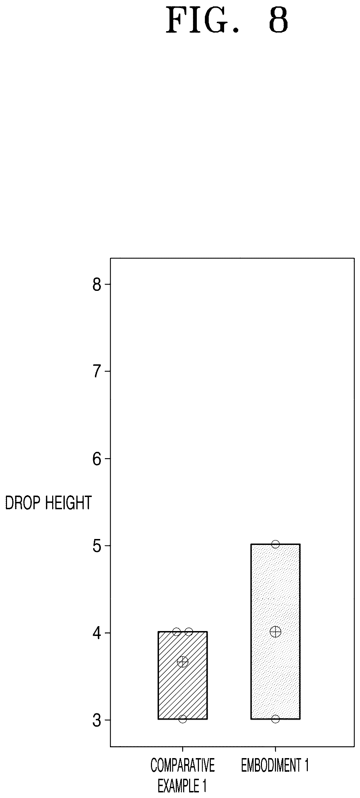

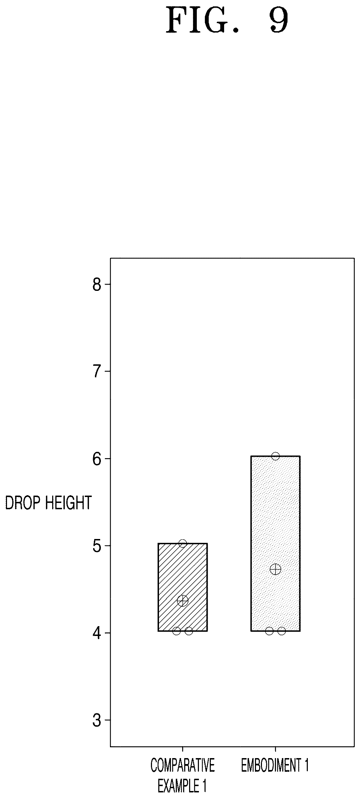

FIG. 8 is a graph showing ball drop evaluation results of display apparatuses according to Embodiment 1 and Comparative Example 1, and FIG. 9 is a graph showing a pen drop evaluation results of display apparatuses according to Embodiment 1 and Comparative Example 1. Embodiment 1 and Comparative Example 1 of FIGS. 8 and 9 are substantially the same as Embodiment 1 and Comparative Example 1 of Tables 3 and 4. For example, Embodiment 1 and Comparative Example 1 of FIGS. 8 and 9 have substantially the same structure as the structure described in one or more embodiments with reference to FIG. 4, and only the first adhesive layer is different, and all other elements except the first adhesive layer are substantially the same.

The ball drop evaluation was performed by vertically free-falling the same ball (e.g., an about 1 g metal ball) on Embodiment 1 and Comparative Example 1, and measuring the height at which each of Embodiment 1 and Comparative Example 1 was broken by the ball. For example, the ball drop evaluation results of FIG. 8 represent the heights at which each of Embodiment 1 and Comparative Example 1 is broken by the ball. Pen drop evaluation was performed by vertically free-falling the same pen (e.g., an about 5.8 g Fine Bic pen from Societe Bic) on Embodiment 1 and Comparative Example 1, and measuring the height at which each of Embodiment 1 and Comparative Example 1 was broken by the pen. For example, the pen drop evaluation results of FIG. 9 represent the heights at which each of Embodiment 1 and Comparative Example 1 is broken by the pen. The drop height on the vertical axis of FIGS. 8 and 9 refers to the height at which the ball or pen is dropped, and the unit is cm.

Referring to FIG. 8, in the ball drop evaluation, the minimum height at which Comparative Example 1 was broken by the ball was about 3 cm, and the average height at which Comparative Example 1 was broken by the ball was about 3.7 cm. In the ball drop evaluation, the minimum height at which Embodiment 1 was broken by the ball was about 3 cm, and the average height at which Embodiment 1 was broken by the ball was about 4 cm.

Referring to FIG. 9, in the pen drop evaluation, the minimum height at which Comparative Example 1 was broken by the pen was about 4 cm, and the average height at which Comparative Example 1 was broken by the pen was about 4.3 cm. In the pen drop evaluation, the minimum height at which Embodiment 1 was broken by the pen was about 4 cm, and the average height at which Embodiment 1 was broken by the pen was about 4.7 cm. For example, Embodiment 1 has a similar impact resistance to an impact resistance of Comparative Example 1.

Accordingly, the display apparatus 10 according to one or more embodiments may be easily folded and may have an excellent or suitable impact resistance. For example, this desired dual performance may be achieved through the utilization of a formulated adhesive composition, as described in one or more embodiments, including a first acrylate-based compound, a second acrylate-based compound with functional groups that enhance flexibility, a siloxane-based compound that contributes to elasticity and thermal stability, and a crosslinking agent that ensures structural integrity. The combination of these components may allow the adhesive layer to maintain adhesion between stacked elements while minimizing or reducing repulsive force during folding and resisting mechanical damage from external impacts. The experimental results, including repulsive force measurements and drop impact evaluations, confirm that the adhesive composition of Embodiment 1 provides a meaningful or substantial improvement over other comparable formulations. For example, the lower repulsive force facilitates smoother folding, while the comparable or improved or enhanced impact resistance ensures durability under stress conditions, such as drops or pressure.

The effect as described herein if (e.g., when) the first adhesive layer AL1 includes a cured material of the adhesive composition may also be applied to the effect if (e.g., when) the second adhesive layer AL2, the third adhesive layer AL3, the fourth adhesive layer AL4, or the fifth adhesive layer AL5 includes a cured material of the adhesive composition. Accordingly, repeated description thereof may not be provided. Although it is illustrated in FIG. 4 that the first adhesive layer AL1 is in direct contact with the display panel DP, embodiments of the present disclosure are not limited thereto.

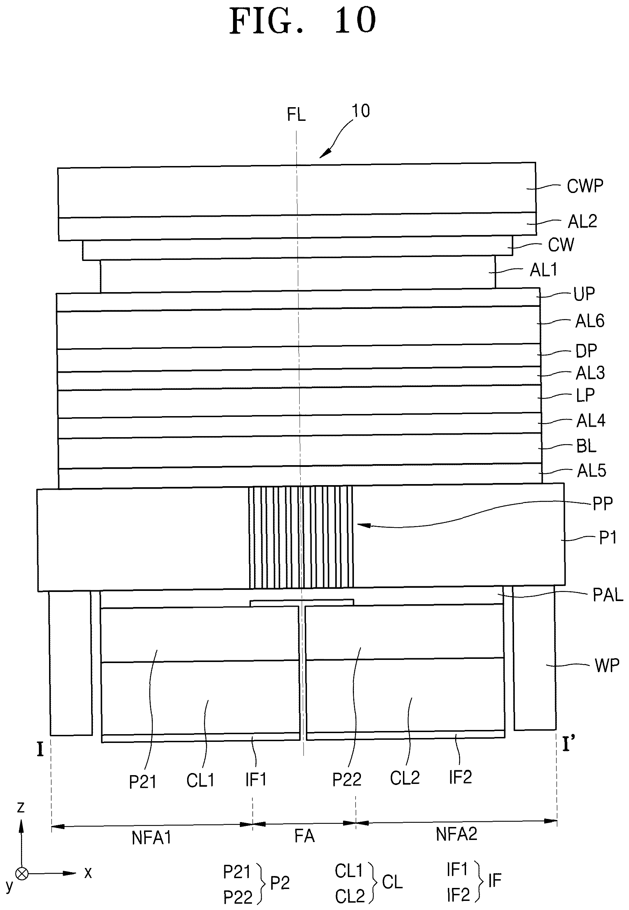

FIG. 10 is a schematic cross-sectional view of the display apparatus 10 according to one or more embodiments. Because the display apparatus 10 according to one or more embodiments is similar to the display apparatus 10 as described in one or more embodiments with reference to FIGS. 2 to 7, differences from the display apparatus 10 as described with reference to FIGS. 2 to 7 may be mainly or predominantly described herein in more detail. In FIG. 10, the same reference numerals as the reference numerals of FIGS. 2 to 7 denote substantially the same members, and thus, repeated descriptions thereof may not be provided.

The display apparatus 10 as described in one or more embodiments with reference to FIGS. 2 to 7 may include the display panel DP, the cover window CW, the window protective layer CWP, the lower protective layer LP, the barrier layer BL, the first plate P1, the second plate P2, the cushion layer CL, and the insulating film IF. In one or more embodiments, the display apparatus 10 as described in one or more embodiments with reference to FIGS. 2 to 7 may include the first adhesive layer AL1, the second adhesive layer AL2, the third adhesive layer AL3, the fourth adhesive layer AL4, and the fifth adhesive layer AL5 and may further include the plate adhesive layer PAL and the waterproof layer WP.

As illustrated in FIG. 10, the display apparatus 10 according to one or more embodiments may include the display panel DP, the cover window CW, the window protective layer CWP, the lower protective layer LP, the barrier layer BL, the first plate P1, the second plate P2, the cushion layer CL, and the insulating film IF. In one or more embodiments, the display apparatus 10 according to one or more embodiments may include the first adhesive layer AL1, the second adhesive layer AL2, the third adhesive layer AL3, the fourth adhesive layer AL4, and the fifth adhesive layer AL5, and may further include the plate adhesive layer PAL and the waterproof layer WP.

However, as illustrated in FIG. 10, the display apparatus according to one or more embodiments may further include an upper protective layer UP and a sixth adhesive layer AL6. The upper protective layer UP may be arranged between the display panel DP and the cover window CW. The upper protective layer UP may be to protect the display panel DP. The upper protective layer UP may be to absorb external impacts applied to the upper surface (a +z direction) of the display panel DP. The upper protective layer UP may include a plastic film including a polymer resin. As an example, the upper protective layer UP may include at least one of polymer resins, such as polyethylene terephthalate (PET), poly(butylene terephthalate) (PBT), polycarbonate (PC), polyethylene naphthalate (PEN), polystyrene (PS), polymethylmethacrylate (PMMA), polyvinylchloride (PVC), polyethersulfone (PES), polypropylene (PP), and polyamide (PA).

In this case, the sixth adhesive layer AL6 may be arranged between the upper protective layer UP and the display panel DP, and the first adhesive layer AL1 may be arranged between the cover window CW and the upper protective layer UP. For example, the sixth adhesive layer AL6 may be in direct contact with the upper protective layer UP and the display panel DP. Accordingly, the sixth adhesive layer AL6 may be arranged to attach the upper protective layer UP to the display panel DP. In this case, the first adhesive layer AL1 may be in direct contact with the upper protective layer UP while being in direct contact with the cover window CW. For example, the first adhesive layer AL1 may be arranged to attach the cover window CW to the display panel DP on which the upper protective layer UP is attached by attaching the cover window CW to the upper protective layer UP.

The sixth adhesive layer AL6 may include substantially the same material as the first adhesive layer AL1. As an example, the sixth adhesive layer AL6 may include a cured material of an adhesive composition including a first acrylate-based compound, a second acrylate-based compound, a siloxane-based compound, and a crosslinking agent. The effect as described herein if (e.g., when) the first adhesive layer AL1 includes a cured material of an adhesive composition including a first acrylate-based compound, a second acrylate-based compound, a siloxane-based compound, and a crosslinking agent may also be applied to the effect if (e.g., when) the sixth adhesive layer AL6 includes a cured material of an adhesive composition including a first acrylate-based compound, a second acrylate-based compound, a siloxane-based compound, and a crosslinking agent. Accordingly, repeated description thereof may not be provided.

According to one or more embodiments having the construction as described herein, an adhesive composition that enables easy folding while providing excellent or suitable impact resistance, as well as a display apparatus and an electronic apparatus incorporating the display apparatus, may be implemented. However, the scope of the present disclosure is not limited by this effects described herein.

A light-emitting device, a display device, a display apparatus, an electronic device, an electronic apparatus, a device for manufacturing substantially the same and/or any other relevant devices or components according to one or more embodiments of the present disclosure may be implemented by utilizing any suitable hardware, firmware (e.g., an application-specific integrated circuit), software, or a (e.g., any suitable) combination of software, firmware, and hardware. For example, the one or more components of the device may be provided on one integrated circuit (IC) chip or on separate IC chips. Further, the one or more components of the device may be implemented on a flexible printed circuit film, a tape carrier package (TCP), and/or a printed circuit board (PCB), or provided on one substrate. Further, the one or more components of the device may be a process or thread, running on one or more processors, in one or more computing devices, executing computer program instructions and interacting with other system components for performing the one or more functionalities described herein. The computer program instructions may be stored in a memory which may be implemented in a computing device utilizing a standard memory device, such as, for example, a random access memory (RAM). The computer program instructions may also be stored in other non-transitory computer readable media, such as, for example, a CD-ROM, flash drive, and/or the like. Also, a person of skill in the art should recognize that the functionality of one or more computing devices may be combined or integrated into a single computing device, or the functionality of a particular computing device may be distributed across one or more other computing devices without departing from the scope of the present disclosure.

It should be understood that embodiments described herein should be considered in a descriptive sense only and not for purposes of limitation. Descriptions of features or aspects within each embodiment should typically be considered as available for other similar features or aspects in other embodiments. While the subject matter of the present disclosure has been described with reference to the drawings, it will be understood by those of ordinary skill in the art that one or more suitable changes in form and more details may be made therein without departing from the scope as defined by the following claims and equivalents thereof.

## Claims

1. An adhesive composition comprising:
a first acrylate-based compound comprising an acryloyl group;
a second acrylate-based compound different from the first acrylate-based compound and comprising at least one selected from among a carboxyl group, a hydroxyl group, an amide group, an amino group, and an epoxy group, and an acryloyl group;
a siloxane-based compound comprising a siloxane group; and
a crosslinking agent.

2. The adhesive composition as claimed in claim 1, wherein, based on 100 wt% of the first acrylate-based compound, the second acrylate-based compound, the siloxane-based compound, and the crosslinking agent, the adhesive composition comprises:
70 wt% to 80 wt% of the first acrylate-based compound;
10 wt% to 20 wt% of the second acrylate-based compound;
1 wt% to 10 wt% of the siloxane-based compound; and
0.1 wt% to 3 wt% of the crosslinking agent.

3. The adhesive composition as claimed in claim 2, wherein:
the second acrylate-based compound comprises at least one selected from among acrylic acid, carboxy ethyl acrylate, carboxy propyl acrylate, carboxy butyl acrylate, hydroxy ethyl acrylate, n-hydroxy propyl acrylate, n-hydroxy butyl acrylate, acrylamide, n-diethyl acrylamide, dimethylaminoethyl acrylate, diethylaminoethyl acrylate, dimethylaminopropyl acrylate, and glycidyl acrylate; and
the siloxane-based compound comprises at least one selected from among polydimethylsiloxane, polymethylphenylsiloxane, and polydiphenylsiloxane.

4. The adhesive composition as claimed in claim 2 or claim 3, wherein:
the first acrylate-based compound comprises a first acrylate-based monomer comprising an acryloyl group and a polymer obtained by polymerizing the first acrylate-based monomer; and
the first acrylate-based monomer comprises at least one selected from among 2-ethylhexyl acrylate, butyl acrylate, and ethyl acrylate.

5. The adhesive composition as claimed in any one of claims 2 to 4, wherein the crosslinking agent comprises at least one selected from 1,6-hexanediol diacrylate and dipentaerythritol hexaacrylate.

6. A display apparatus (10) comprising:
a display panel (DP) comprising a display element (310);
a cover window (CW) on the display panel (DP); and
a first adhesive layer (AL1) between the display panel (DP) and the cover window (CW) and comprising a cured material of an adhesive composition,
wherein the adhesive composition comprises:
a first acrylate-based compound comprising an acryloyl group;
a second acrylate-based compound different from the first acrylate-based compound and comprising at least one selected from among a carboxyl group, a hydroxyl group, an amide group, an amino group, and an epoxy group, and an acryloyl group;
a siloxane-based compound comprising a siloxane group; and
a crosslinking agent.

7. The display apparatus (10) as claimed in claim 6, wherein, based on 100 wt% of the first acrylate-based compound, the second acrylate-based compound, the siloxane-based compound, and the crosslinking agent, the adhesive composition comprises:
70 wt% to 80 wt% of the first acrylate-based compound;
10 wt% to 20 wt% of the second acrylate-based compound;
1 wt% to 10 wt% of the siloxane-based compound; and
0.1 wt% to 3 wt% of the crosslinking agent.

8. The display apparatus (10) as claimed in claim 7, wherein:
(i) the second acrylate-based compound comprises at least one selected from among acrylic acid, carboxy ethyl acrylate, carboxy propyl acrylate, carboxy butyl acrylate, hydroxy ethyl acrylate, n-hydroxy propyl acrylate, n-hydroxy butyl acrylate, acrylamide, n-diethyl acrylamide, dimethylaminoethyl acrylate, diethylaminoethyl acrylate, dimethylaminopropyl acrylate, and glycidyl acrylate; and
the siloxane-based compound comprises at least one selected from among polydimethylsiloxane, polymethylphenylsiloxane, and polydiphenylsiloxane; and/or
(ii) the first acrylate-based compound comprises a first acrylate-based monomer comprising an acryloyl group and a polymer obtained by polymerizing the first acrylate-based monomer; and
the first acrylate-based monomer comprises at least one selected from among 2-ethylhexyl acrylate, butyl acrylate, and ethyl acrylate; and/or
(iii) the crosslinking agent comprises at least one selected from 1,6-hexanediol diacrylate and dipentaerythritol hexaacrylate.

9. The display apparatus (10) as claimed in any one of claims 6 to 8, further comprising:
a window protective layer (CWP) on the cover window (CW); and
a second adhesive layer (AL2) between the cover window (CW) and the window protective layer (CWP),
wherein the second adhesive layer (AL2) comprises substantially the same material as the first adhesive layer (AL1).

10. The display apparatus (10) as claimed in any one of claims 6 to 9, further comprising:
a lower protective layer (LP) under the display panel (DP);
a barrier layer (BL) under the lower protective layer (LP);
a support layer under the barrier layer (BL); and
a third adhesive layer (AL3) between the display panel (DP) and the lower protective layer (LP),
wherein the third adhesive layer (AL3) comprises substantially the same material as the first adhesive layer (AL1).

11. The display apparatus (10) as claimed in claim 10, further comprising:
(i) a fourth adhesive layer (AL4) between the lower protective layer (LP) and the barrier layer (BL),
wherein the fourth adhesive layer (AL4) comprises substantially the same material as the first adhesive layer (AL1); and/or
(ii) a fifth adhesive layer (AL5) between the barrier layer (BL) and the support layer,
wherein the fifth adhesive layer (AL5) comprises substantially the same material as the first adhesive layer (AL1).

12. The display apparatus (10) as claimed in any one of claims 6 to 11, further comprising:
an upper protective layer (UP) between the display panel (DP) and the cover window (CW); and
a sixth adhesive layer (AL6) between the display panel (DP) and the upper protective layer (UP),
wherein the first adhesive layer (AL1) is between the upper protective layer (UP) and the cover window (CW), and the sixth adhesive layer (AL6) comprises substantially the same material as the first adhesive layer (AL1).

13. The display apparatus (10) as claimed in any one of claims 6 to 12, wherein the display apparatus (10) comprises a first non-folding area (NFA1), a second non-folding area (NFA2), and a foldable area (FA) between the first non-folding area (NFA1) and the second non-folding area (NFA2), optionally wherein the display apparatus (10) is configured to be folded such that a portion of one surface (S1) of the display apparatus (10) and another portion of the one surface (S1) of the display apparatus (10) are opposite to each other.

14. An electronic apparatus (1) comprising:
a processor (12); and
a display apparatus (10) controlled by the processor (12),
wherein the display apparatus (10) comprises:
a display panel (DP) comprising a display element (310);
a cover window (CW) on the display panel (DP); and
a first adhesive layer (AL1) between the display panel (DP) and the cover window (CW) and comprising a cured material of an adhesive composition, and
wherein the adhesive composition comprises:
a first acrylate-based compound comprising an acryloyl group;
a second acrylate-based compound different from the first acrylate-based compound and comprising at least one selected from among a carboxyl group, a hydroxyl group, an amide group, an amino group, and an epoxy group, and an acryloyl group;
a siloxane-based compound comprising a siloxane group; and
a crosslinking agent.

15. The electronic apparatus (1) as claimed in claim 14, wherein:
(i) based on 100 wt% of the first acrylate-based compound, the second acrylate-based compound, the siloxane-based compound, and the crosslinking agent, the adhesive composition comprises:
70 wt% to 80 wt% of the first acrylate-based compound;
10 wt% to 20 wt% of the second acrylate-based compound;
1 wt% to 10 wt% of the siloxane-based compound; and
0.1 wt% to 3 wt% of the crosslinking agent; and/or
(ii) the display apparatus (10) comprises a first non-folding area (NFA1), a second non-folding area (NFA2), and a foldable area (FA) between the first non-folding area (NFA1) and the second non-folding area (NFA2), and
wherein the display apparatus (10) is configured to be folded such that a portion of one surface (S1) of the display apparatus (10) and another portion of the one surface (S1) of the display apparatus (10) are opposite to each other.
